(19)

Europäisches
Patentamt

European
Patent Office

Office européen
des brevets

(11)  **EP 4 542 631 A2**

(12)  **EUROPEAN PATENT APPLICATION**

(43) Date of publication:
**23.04.2025   Bulletin 2025/17**

(21) Application number: **24197356.9**

(22) Date of filing: **29.08.2024**

(51) International Patent Classification (IPC):
**H01L 21/56** (2006.01)     **H01L 21/683** (2006.01)
**H01L 21/67** (2006.01)     **H01L 21/60** (2006.01)

(52) Cooperative Patent Classification (CPC):
**H01L 21/568; H01L 21/6835;** H01L 21/67005;
H01L 25/0652; H01L 25/105; H01L 2021/6006;
H01L 2221/68304; H01L 2221/68318;
H01L 2221/68322; H01L 2221/6834;
H01L 2221/68363; H01L 2221/68368;
H01L 2221/68381; H01L 2225/06548

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **29.09.2023   US 202318478729**

(71) Applicant: **INTEL Corporation
Santa Clara, CA 95054 (US)**

(72) Inventors:
• **SOUNART, Thomas L.
Chandler 85226 (US)**
• **ELSHERBINI, Adel A.
Chandler 85248 (US)**
• **EID, Feras
Chandler 85226 (US)**
• **TALUKDAR, Tushar
Wilsonville 97124 (US)**
• **VYATSKIKH, Andrey
Hillsboro 97123 (US)**

(74) Representative: **2SPL Patentanwälte PartG mbB
Landaubogen 3
81373 München (DE)**

(54)  **STRUCTURAL SUPPORT LAYER TO PROTECT SELECTIVE TRANSFER LAYER DURING LASER EXPOSURE OF UNBONDED WAFERS**

(57)   An embodiment discloses a method comprising receiving a substrate comprising a first layer, a second layer over the first layer, and a third layer over the second layer, the second layer comprising at least one integrated circuit (IC) component, the third layer comprising at least one dielectric material; and using a laser to weaken the first layer to facilitate separation of the second layer from the substrate.

**FIG. 15**

EP 4 542 631 A2

## Description

## BACKGROUND

In semiconductor manufacturing, layer transfer techniques are used to transfer a layer from one substrate to another, typically at wafer-level scale. These techniques require a full layer to be transferred in its entirety regardless of whether the entire layer is needed. As a result, any unneeded portions of a transferred layer must be etched off after the transfer, which increases costs and process complexity.

## BRIEF DESCRIPTION OF THE DRAWINGS

FIGS. 1A-I illustrate an example process flow for selective layer transfers using selective release techniques.

FIGS. 2A-I illustrate an example process flow for selective layer transfers using a blanket laser exposure.

FIGS. 3A-I illustrate an example process flow for selective layer transfers from a singulated donor substrate.

FIGS. 4A-C illustrate an example process flow for selective layer transfers from multiple donor substrates.

FIGS. 5A-F illustrate an example process flow for forming an integrated circuit package using a selective transfer of a passive interposer.

FIGS. 6A-B illustrate an example of a selective layer transfer between wafers.

FIG. 7 illustrates a flowchart for performing selective layer transfers.

FIGS. 8A-E illustrate an example process flow for selective transfers using blanket wafer laser exposure.

FIGS. 9A-C illustrate various laser debonding techniques for selective transfers.

FIGS. 10A-B illustrate laser debonding techniques that put selective transfer layers at risk of damage.

FIG. 11 illustrates an example structural support layer to protect a selective transfer layer.

FIGS. 12A-D illustrate an example process flow for selective layer transfers using a structural support layer.

FIGS. 13A-D illustrate an example process flow for selective layer transfers using a structural support layer comprising glass and a light release adhesive.

FIG. 14 illustrates an example wafer chuck with a porous portion having small pores relative to a laser spot size.

FIG. 15 illustrates a flowchart for performing selective layer transfers using a structural support layer.

FIG. 16 illustrates a debonding stack on a donor substrate.

FIG. 17 illustrates a protective debonding stack comprising a transformation layer on a donor substrate.

FIG. 18 illustrates a protective debonding stack comprising a compressive stress layer on a donor substrate.

FIG. 19 illustrates a protective debonding stack comprising a patterned layer on a donor substrate.

FIG. 20A-E illustrate example patterned layers.

FIG. 21 illustrates a protective debonding stack comprising a reflector stack on a donor substrate.

FIG. 22 illustrates a flowchart for performing selective layer transfers using a protective debonding stack.

FIG. 23 illustrates a top view of a wafer and dies that may be included in a microelectronic assembly.

FIG. 24 illustrates a cross-sectional side view of an integrated circuit device that may be included in a microelectronic assembly.

FIGS. 25A-D illustrate perspective views of example planar, FinFET, gate-all-around, and stacked gate-all-around transistors.

FIG. 26 illustrates a cross-sectional side view of an integrated circuit device assembly that may include a microelectronic assembly.

FIG. 27 illustrates a block diagram of an example electrical device that may include a microelectronic assembly.

## DETAILED DESCRIPTION

*Selective Layer Transfer*

In semiconductor manufacturing, layer transfer techniques are used to transfer a layer from one substrate to another, typically at wafer-level scale. Layer transfers are useful for a variety of applications in semiconductor manufacturing, including two-dimensional (2D) material fabrication, Group III-V semiconductors over complementary metal-oxide semiconductors (CMOS), and traditional CMOS applications such as metal-insulator-metal (MIM) devices and thin device and/or interconnect layer transfers. Current layer transfer techniques are limited to full layer transfers, however, which may impact cost and performance when the full layer is not needed. For example, blanket layer transfer techniques, such as ion-cut and laser debonding layer transfers, require a full layer to be transferred in its entirety. As a result, any unneeded areas of the transferred layer must be etched off after the transfer, which results in added cost and process complexity.

Alternatively, pick-and-place techniques can be used to transfer specific dies or chiplets. For example, a chiplet generally refers to an integrated circuit (IC) that contains a well-defined subset of functionality, which is designed to be combined with other chiplets to form a single IC package. To transfer chiplets (e.g., for MIM chiplet integration in a system-on-a-chip (SoC)), chiplet devices are fabricated on a donor substrate (e.g., a wafer or panel), the donor substrate is singulated into chiplets, and the chiplets are then individually attached to a receiver substrate (e.g., an SoC wafer or package) using pick-and-place machines. This adds significant cost due to the extra processing required to singulate the wafer and individually attach the respective chiplet dies. For example, chiplets are generally manufactured on relatively thick substrates to enable them to be handled during the singulation and attach steps without being damaged, and after the attach step, additional processing is performed to thin the chiplets and/or remove the carrier substrate, which further increases the cost and process complexity. In particular, chiplets are typically manufactured on substrates that are over 700 micrometers ($\mu$m or microns) thick to provide structural and mechanical stability during fabrication, and after the singulation/attach steps, they may be thinned to approximately 20-100 $\mu$m by grinding the backside. However, grinding typically causes chipping along the edges of the chiplet dies. Further, it can be challenging to thin chiplets beyond 20 $\mu$m without producing defects. Similarly, chiplets are typically singulated with a die area on the millimeter level scale, as pick-and-place assembly becomes very challenging for chiplets smaller than 1 millimeter (mm)$^2$.

Integrated circuits can also be manufactured monolithically, where all IC components and interconnections are fabricated sequentially on the same underlying substrate or wafer. Monolithic ICs have various limitations, however, including design limitations due to incompatible processes, lack of flexibility, and low yield.

Accordingly, this disclosure presents selective layer transfer techniques for selectively transferring portions of a layer between substrates, along with devices and systems formed using the same. For example, one or more of the described techniques enable select areas on a donor substrate to be transferred to a receiver substrate, which enables the donor substrate to be reused multiple times, while also addressing the limitations described above for blanket layer transfers and pick and place techniques. In particular, the described solution (e.g., one or more of the embodiments described herein) uses a selective release technology on a donor substrate (e.g., wafer, panel, or die) in conjunction with a patterned bonding template on a receiver substrate (e.g., wafer, panel, or die) to allow select areas of a layer on the donor substrate to be transferred to the receiver substrate. For purposes of this disclosure, the term layer may sometimes be used to refer to a single layer of a single material or multiple layers of one or more materials. For example, a selective transfer layer may be formed on a substrate, and may be an individual layer of material, or a stack of layers that collectively form a layer of IC components (e.g., dies, interconnects, bridges, capacitors, and/or other semiconductor devices). A layer may also include stacked wafers, such as wafer-to-wafer bonded and stacked logic and/or memory wafers. As an example, a donor wafer may include a layer of IC components (e.g.,

IC dies), and a selective layer transfer may be used to selectively and simultaneously transfer a specific subset of those IC components to a receiver wafer.

The described solution provides various advantages. For example, the described solution enables select areas of a donor wafer to be transferred as opposed to an entire layer, which enables the donor wafer to be reused for multiple products, thus amortizing the cost of expensive devices (e.g., high-density MIM capacitors or high-density passive interposers) across multiple wafers. This solution also eliminates the need to etch away superfluous areas as required by full layer transfers (and as a result, unlike the etched areas after a full layer transfer, selectively transferred areas may not have tapered edges from etching or may have reversed tapering due to the etch to singulate before transfer).

Further, in various examples, layers of IC components can be selectively transferred at any suitable level of granularity, including full IC dies and packages, interconnects, transistors, resistors, capacitors, partial layers or layer stacks, etc.

This solution also enables areas of ultra-thin layers to be selectively transferred without the added processing and yield loss resulting from the handling challenges of chiplet pick-and-place methods (e.g., singulation, individually attaching each chiplet, post-attach thinning of chiplets). This helps reduce the Z-height of a product (e.g., for form factor, thermal, and/or power delivery reasons) as well as the overall process complexity. For example, very thin IC dies or chiplets can be formed on any substrate and selectively transferred directly from that substrate. As a result, selectively transferring the dies not only eliminates the need for post-attach thinning, it also enables the dies to be much thinner than dies that are singulated, pick-and-place attached, and then subsequently thinned. In some cases, for example, the described solution may enable transfers of dies with thicknesses ranging from 100 nanometers (nm) to 5 $\mu$m or more. Further, since no post-attach thinning is needed, the selectively transferred dies may have no or minimal chipping on the die edges since no grinding is performed, unlike chiplets that are thinned after attachment.

Similarly, the described solution supports selective transfers of very small areas on a donor substrate, such as very small dies or chiplets, which is extremely challenging using pick-and-place techniques. In some cases, for example, the described solution may enable transfers of dies (or other IC components) with an area less than 1 mm$^2$, such as 100 $\mu$m$^2$ (10$\times$10 $\mu$m), 10,000 $\mu$m$^2$ (100x100 $\mu$m), 810,000 $\mu$m$^2$ (900x900 $\mu$m), etc. (with no limits on the maximum size of an area that can be selectively transferred).

This solution also supports selective transfers of dies with non-standard shapes and designs that are difficult to handle using pick-and-place machines, such as dies with atypical, arbitrary, irregular, or non-convex shapes (e.g., L shape, U shape, shapes with acute angles), dies with high aspect ratios (e.g., 8:1 aspect ratio or higher), dies with holes, and so forth.

Further, this solution has very low topography and supports high surface cleanliness and planarization (e.g., using chemical mechanical polishing (CMP) processing), which makes it compatible with hybrid bonding and fusion bonding processing. Additional advantages are described throughout this disclosure and apparent from the description below.

Accordingly, this solution enables complex IC packages and products to be manufactured by selectively transferring certain components (e.g., active circuitry such as IC dies, passive circuitry) instead of incorporating them using traditional processes, such as: (i) full layer transfers with superfluous areas etched away; (ii) pick-and-place assembly of individual IC components; and/or (iii) monolithic IC fabrication.

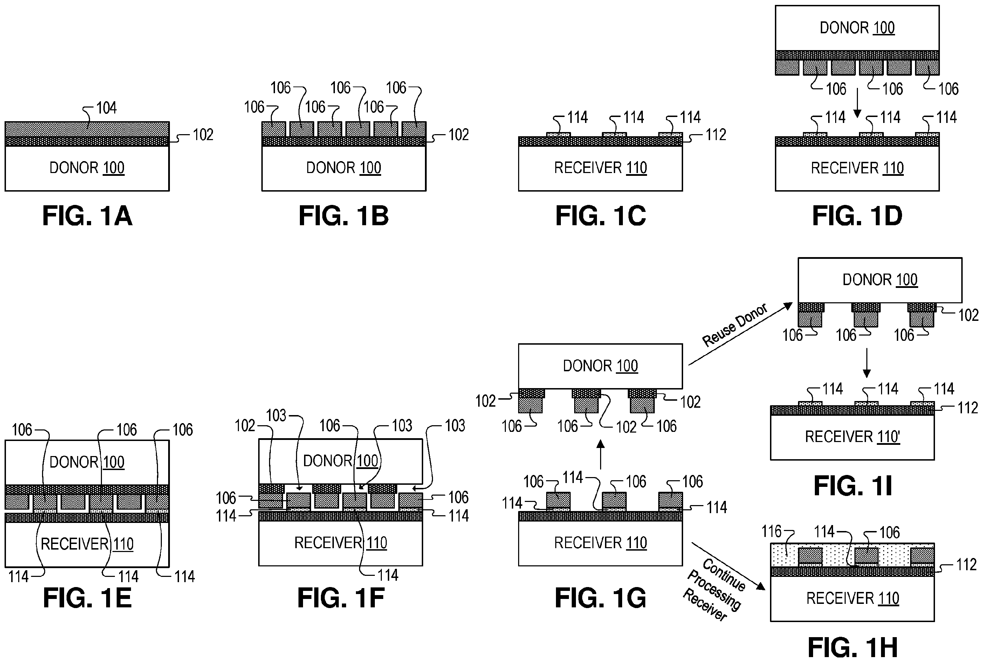

**FIGS. 1A-I** illustrate an example process flow for selective layer transfers using selective release techniques. In the illustrated example, a layer of integrated circuit (IC) components is selectively transferred from a donor substrate 100 to a receiver substrate 110, as described further below.

In FIG. 1A, a release layer 102 is formed over a carrier substrate, which is referred to as the donor substrate 100. The release layer 102 is a temporary bonding and debonding layer for the layer 104 to be selectively transferred. In some embodiments, the release layer 102 may include one or more layers and/or materials capable of providing adhesion to the donor substrate 100 and/or absorbing energy from a laser (e.g., laser beams), such as lossy dielectric and/or thin metal layer(s) that provide adhesion and absorb/reflect infrared (IR) light, organic polymer layer(s) (e.g., polyimides) that provide adhesion and absorb visible or ultraviolet (UV) light, and/or patterned dielectric layer(s) with anchors to provide residual adhesion (e.g., after the metal layer is ablated by an IR laser).

The layer 104 to be selectively transferred is formed over the release layer 102 on the donor substrate 100, such as by fabricating the layer 104 directly (e.g., over the release layer 102) or blanket transferring the layer 104. The selective transfer layer 104 may include one or more layers of material, such as a single layer of material or a stack of layers that collectively form a layer of IC components (e.g., full IC dies, chiplets, interconnects, bridges, capacitors, transistors, and/or other semiconductor devices). In some embodiments, for example, the selective transfer layer 104 may be a prefabricated semiconductor wafer containing unsingulated integrated circuit (IC) dies, which is blanket transferred to the release layer 102 on a donor substrate 100.

In FIG. 1B, the selective transfer layer 104 is diced over the donor substrate 100-without dicing through the donor substrate 100-to partially singulate the IC components 106 in the layer 104, using techniques such as etching, reactive ion etching (RIE), plasma dicing, mechanical sawing, etc. In some embodiments, the release layer 102 may also be singulated (e.g., diced or etched) along with the transfer layer 104.

In FIG. 1C, a release layer 112 is optionally formed over another carrier substrate, which is referred to as the receiver substrate 110. For example, the release layer 112 may be formed over the receiver substrate 110 if the selectively transferred IC components 106 will be subsequently debonded from the receiver substrate 110 after the transfer. Otherwise, if the selectively transferred IC components 106 will remain on the receiver substrate 110 after the transfer, the release layer 112 on the receiver substrate 110 may be omitted.

Next, a bonding template comprising bonding features 114 is formed on the surface of the receiver substrate 110 (e.g., above the release layer 112, if included). The bonding template includes a pattern of bonding features 114 or adhesive areas that enable specific areas on the donor substrate 100 to be selectively transferred to the receiver substrate 110. For example, the positions of the bonding features 114 or adhesive areas on the receiver substrate 110 correspond to the areas or IC components 106 on the donor substrate 100 that will be transferred to the receiver substrate 110.

In some embodiments, for example, the bonding features 114 may include "island" or "mesa" structures that are similar in size to the target areas to be transferred from the donor substrate 100. For example, each island or mesa structure may be a raised structure on the surface of the receiver substrate 110 with a similar footprint (e.g., shape/surface area) as a corresponding IC component 106 on the donor substrate 100. In other embodiments, the bonding features 114 may be replaced by lithographically or additively manufactured surface treatments that enhance the adhesion in the target areas of the receiver substrate 110 (e.g., the areas where the bonding features 114 are shown) and prevents adhesion in the other areas, including, without limitation, surface topography variations, use of materials with high and/or low adhesion, treatments using hydrophobic materials and/or self-assembled monolayers (SAMs), and/or surface activation techniques, among other examples.

In various embodiments, these bonding features 114 may be made of dielectric materials, conductive materials (e.g., metal), or both, depending on whether electrical connections are needed between the bonded IC components 106 and the receiver substrate 110. For example, the bonding features 114 may be blanket dielectric structures with no electrical contacts, or they may be dielectric structures with electrical contacts through them (e.g., hybrid bonding pads) if electrical connections are needed through the bonding interface.

In FIG. 1D, the donor and receiver substrates 100, 110 are brought into contact with each other with their top surfaces aligned face to face, such that the target IC components 106 on the donor substrate 100 are aligned with corresponding bonding features 114 on the receiver substrate 110.

In FIG. 1E, the donor and receiver substrates 100, 110 are partially bonded together. For example, the areas of the receiver substrate 110 with protruding surface features or "mesas" are bonded to corresponding areas on the donor substrate 100 with the target IC components 106, while other areas of the donor and receiver substrates 100, 110 remain unbonded. In some embodiments, for example, this is controlled through the height of the bonding protrusions (e.g., bonding features 114) to prevent unwanted contact between areas that are not to be transferred. As previously mentioned, this can also be controlled through surface treatment of the different areas to enable good adhesion in the target areas (e.g., where the bonding features 114 are shown) and prevent or reduce adhesion in other areas.

In FIG. 1F, the IC components 106 bonded to the receiver substrate 110 are selectively debonded from the donor substrate 100 using selective release techniques, such as IR debonding, selective visible or ultraviolet (UV) laser exposure, etc. For example, areas 103 of the release layer 102 where those IC components 106 are bonded to the donor substrate 100 may be selectively removed or ablated using a laser, such as an IR or UV laser, which forms gaps or voids in the release layer 102 and causes those IC components 106 to be released from the donor substrate 100.

In FIG. 1G, the donor and receiver substrates 100, 110 are mechanically separated from each other. At this point, the IC components 106 that were selectively bonded to the receiver substrate 110 (e.g., via the bonding features 114) and debonded from the donor substrate 100 remain on the receiver substrate 110 and are separated from the donor substrate 100. All other IC components 106 that were not bonded to the receiver substrate 110 remain on the donor substrate 100.

In FIG. 1H, the receiver substrate 110 is now ready for continued processing, such as dielectric fill 116 around the transferred IC components 106, planarization, selectively transferring or pick-and-place attaching additional IC dies or other IC components, via formation, formation of interconnect/metallization layers, attaching a structural substrate, debonding the receiver substrate (e.g., via the optional receiver release layer 112), and/or any other processing required for the finished product (e.g., an IC package).

In FIG. 1I, the donor substrate 100 is then reused to transfer the remaining IC components 106 (e.g., the remaining areas of the selectively transferred layer 104) to a new receiver substrate 110'. The donor substrate 100 can continue being reused in this manner until all IC components 106, or the entire layer 104, have been selectively transferred to any number of receiver substrates 110.

It should be appreciated that the illustrated process flow for selective layer transfers is merely presented as an example and many other process variations are also possible. For example, the donor and receiver substrates 100, 110 may be wafers, panels, IC packages, chiplets, dies, or any combination thereof (e.g., for transfers from wafer to panel, chiplet to wafer, etc.). Moreover, each substrate 100, 110 may be made of a variety of materials, including, without limitation, inorganic materials such as silicon, silicon on insulator (SOI), quartz, glass, and/or Group III-V materials, organic materials such as IR or UV transparent epoxies, and so forth.

The materials used in the release layers 102, 112 may vary depending on the type of release or debonding technology used. For example, for infrared (IR) laser debonding, the release layers 102, 112 may include one or more materials capable of absorbing and/or reflecting infrared (IR) light, such as a thin metal layer or multiple metal layers (e.g., aluminum (Al), tungsten (W), copper (Cu), titanium (Ti), titanium nitride (TiN), tantalum (Ta), tantalum nitride (TaN)). For ultraviolet (UV) laser debonding, the release layers 102, 112 may include one or more materials capable of absorbing UV light (e.g., a wide range of organic polymers, including, but not limited to, polyimides). In some embodiments, the release layers 102, 112 may additionally or alternatively include one or more layers of dielectric materials (e.g., silicon dioxide $(SiO_2)$, silicon nitride $(Si_3N_4)$, silicon oxynitride (SiON), silicon carbide (SiC), silicon carbon nitride (SiCN), silicon oxycarbon nitride (SiOCN), aluminum oxide $(Al_2O_3)$, low-k dielectrics such as carbon-doped oxide (CDO) or porous silicon dioxide $(SiO_2)$, titanium dioxide $(TiO_2)$, tantalum oxide $(Ta_2O_5)$), which may be used to buffer laser ablation and thermal energy, control thin film interference or adhesion, and/or provide residual adhesion after other materials and/or layers in the release layers 102, 112 are weakened, removed, and/or ablated by a laser.

The number of layers 104 on the donor substrate 100, the arrangement/structure of the layers 104, the materials in each layer 104, and the type of IC components 106 formed in those layers 104 may vary.

The adhesive areas or bonding features 114 on the receiver substrate 110 may be formed using any suitable surface treatments or other techniques to control the level of adhesion in different areas, including, without limitation, surface topography variations (e.g., mesas, recesses), use of materials with high and/or low adhesion, treatments using hydrophobic materials and/or self-assembled monolayers (SAMs), and/or surface activation techniques, among other examples. Moreover, the bonding features 114 or adhesive areas on the receiver substrate 110 may vary in size, shape, height, topography, pattern, and materials. For example, the bonding features 114 may be formed using inorganic dielectrics such as silicon dioxide $(SiO_2)$, silicon nitride $(Si_3N_4)$, silicon oxy nitride (SiON), and/or silicon carbon nitride (SiCN), organic dielectrics such as photoresists and adhesives, conductive materials such as metals, and combinations thereof.

The donor and receiver substrates 100, 110 may be (partially) bonded using any suitable bonding techniques, including, without limitation, hybrid bonding, fusion bonding, and adhesive bonding. The donor and receiver substrates 100, 110 may be debonded or released using any suitable debonding techniques, including, without limitation, IR and UV laser debonding. Further, there may be additional cleaning steps to reuse the donor substrate 100 before or after each selective layer transfer to a receiver substrate 110.

Further, in some embodiments, additional bonding and/or alignment features may be included at the wafer level and/or die level (e.g., on the donor dies, donor wafer, receiver wafer, and/or final product). For example, the donor and/or receiver wafer may include ridge or cross structures to facilitate bonding, such as a single ridge (e.g., a line or strip of dielectric material) extending across and/or through the center of the wafer, or multiple orthogonal ridges forming a cross-like pattern. Alignment features for wafers, die-lets, and/or die arrays may also be included to facilitate bonds with proper alignment. Further, multiple dies may be connected by small (e.g., dielectric) bridges to help them collectively bond and transfer together. For example, if some of the bridge-connected dies successfully bond to the receiver, the bridges may help others bond as well. Thus, these inter-die bridges may be present on the donor before the transfer, and on the receiver and final product after the transfer.

Further, in some cases, the debonding process may cause some unique damage or delamination near the edge and/or on the back of the dies, which does not impact process performance but may be indicative of this solution being used.

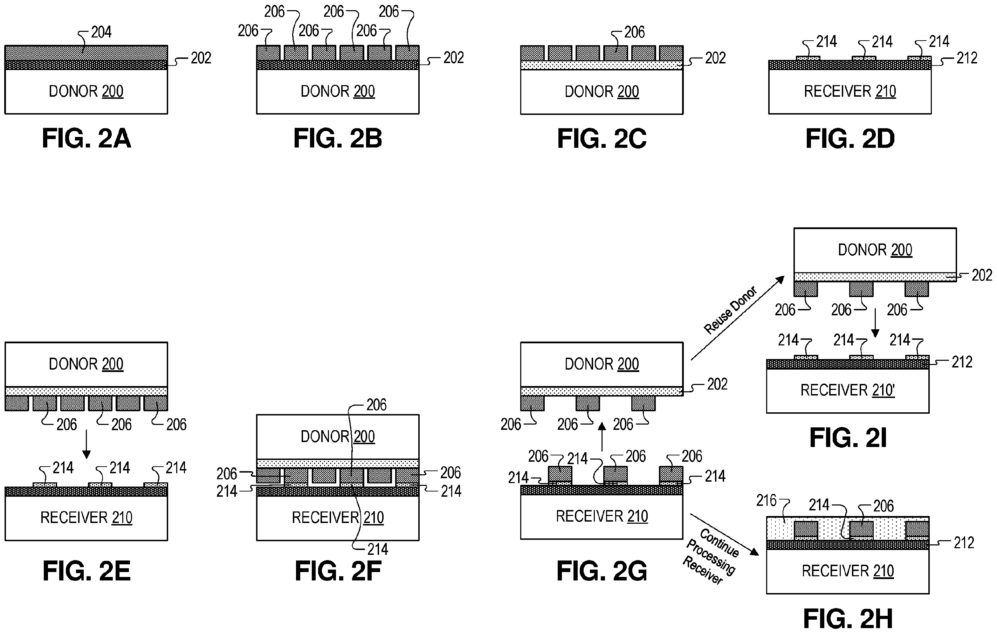

FIGS. 2A-I illustrate an example process flow for selective layer transfers using a blanket laser exposure. In the illustrated example, a layer 204 of integrated circuit (IC) components 206 is selectively transferred from a donor substrate 200 to a receiver substrate 210. Prior to the transfer, however, the entire release layer 202 on the donor 200 is mechanically weakened (e.g., using IR laser, visible light laser, UV laser, chemical etching, and/or thermal techniques), which may also be referred to as a partial release. In this manner, after the target IC components 206 on the donor 200 are bonded to the receiver 210, they can be fully released from the donor 200 by mechanically separating the donor 200 from the receiver 210. In some cases, this may result in a simplified and faster bond/debond flow compared to the bond/selective release/debond flow of FIGS. 1A-I . Other variations of this flow are described in connection with other FIGS. herein. Alternatively, rather than using blanket laser exposure, the respective materials used in the donor release layer 202 and the receiver bonding template 214 may be selected such that the bond to the donor 200 is weaker than the subsequently formed bond to the receiver 210.

In FIG. 2A, a release layer 202 is formed over a donor substrate 200. The layer 204 to be selectively transferred is formed over the release layer 202, such as by fabricating the layer 204 directly (e.g., over the release layer 202) or blanket transferring the layer 204. In some embodiments, the selective transfer layer 204 may be a layer of IC components (e.g., IC dies, chiplets, interconnects, bridges, capacitors, transistors, and/or other semiconductor devices).

In FIG. 2B, the selective transfer layer 204 is diced over the donor substrate 200-without dicing through the entire donor substrate 200-to partially singulate the IC components 206 in the layer 204.

In FIG. 2C, blanket laser exposure is performed on the donor release layer 202 to weaken the entire release layer 202 prior to the transfer. In some embodiments, for example, blanket laser exposure may be performed using laser (e.g., IR or UV laser exposure), chemical, and/or thermal techniques. In this manner, the weakened release layer 202 has lower bond energy, which results in a partial release of the IC components 206 bonded to that layer 202.

In FIG. 2D, a release layer 212 is optionally formed over a receiver substrate 210. For example, if the selectively transferred IC components 206 will be subsequently debonded from the receiver substrate 210 after the transfer, a release layer 212 may be formed over the receiver 210; otherwise, the release layer 212 on the receiver 210 may be omitted.

Next, a bonding template 214 is formed on the surface of the receiver substrate 210 (e.g., above the release layer 212, if included). The bonding template 214 includes a pattern of bonding features or adhesive areas, such as mesas, that enable specific areas on the donor substrate 200 to be selectively transferred to the receiver substrate 210. In various embodiments, however, any suitable surface treatments or other techniques may be used to control the level of adhesion on different areas of the receiver substrate 210 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 2E, the donor and receiver substrates 200, 210 are brought into contact with each other with their top surfaces aligned face to face, such that the target IC components 206 on the donor 200 are aligned with corresponding bonding features of bonding template 214 on the receiver 210.

In FIG. 2F, the donor and receiver substrates 200, 210 are partially bonded together, where the areas of the donor 200 with the target IC components 206 are bonded to the areas on the receiver 210 with bonding mesas of bonding template 214.

In FIG. 2G, the donor and receiver substrates 200, 210 are mechanically separated from each other. At this point, the IC components 206 that were selectively bonded to the receiver 210 (e.g., via the bonding mesas of bonding template 214) remain on the receiver 210 and are debonded/separated from the donor 200 due to the blanket weakening of the donor release layer 202. All other IC components 206 that were not bonded to the receiver 210 remain on the donor 200.

Alternatively, in some embodiments, instead of (or in addition to) performing blanket laser exposure in FIG. 2C, the respective materials used in the donor release layer 202 and the receiver bonding template 214 may be selected such that the target IC components 206 will have a stronger bond to the receiver 210 than the donor 200. In this manner, when the donor 200 and receiver 210 are mechanically separated, the target IC components 206 will debond from the donor 200 and remain on the receiver 210 due to the disparity in bond strength.

In FIG. 2H, the receiver substrate 210 is ready for continued processing, such as dielectric fill 216 around the transferred IC components 206, planarization, selectively transferring or pick-and-place attaching additional IC dies or other IC components, via formation, formation of interconnect/metallization layers, attaching a structural substrate, debonding the receiver substrate (e.g., via the optional receiver release layer 212), and/or any other processing required for the finished product (e.g., an IC package).

In FIG. 2I, the donor substrate 200 is then reused to transfer the remaining IC components 206 (e.g., the remaining areas of the selectively transferred layer 204) to a new receiver substrate 210'. The donor substrate 200 can continue being reused in this manner until all IC components 206, or the entire layer 204, have been selectively transferred to any number of receiver substrates 210.

Elements labeled with reference numerals in FIGS. 2A-I may be similar to those having similar reference numerals in **FIGS. 1A-I** . Further, it should be appreciated that the illustrated process flow for selective layer transfers is merely presented as an example and many other process variations are also possible, including, but not limited to, the process variations described throughout this disclosure.

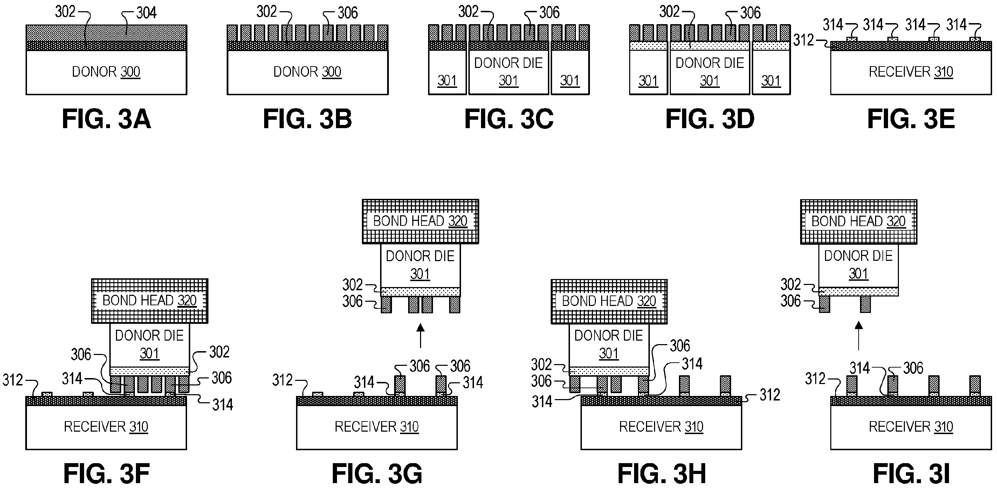

**FIGS. 3A-I** illustrate an example process flow for selective layer transfers from a singulated donor substrate 300. In some cases, for example, if the percentage of transferred integrated circuit (IC) components 306 is relatively small for each selective layer transfer, it may be easier and more cost efficient to dice the donor substrate 300 and perform the transfers from singulated donor dies 301 that contain smaller subsets of IC components 306 from the original donor substrate 300. Accordingly, in the illustrated example, a donor substrate 300 with a layer 304 of IC components 306 is diced, and the resulting layer of IC components 306 on a singulated donor die 301 is selectively transferred to a receiver substrate 310. In this manner, the transfers are performed at the donor die level rather than the wafer or panel level.

In FIG. 3A, a release layer 302 is formed over a donor substrate 300. The layer 304 to be selectively transferred is formed over the release layer 302, such as by fabricating the layer 304 directly or blanket transferring the layer 304. In some embodiments, the selective transfer layer 304 may be a layer of IC components (e.g., IC dies, chiplets, interconnects, bridges, capacitors, transistors, and/or other semiconductor devices).

In FIG. 3B, the selective transfer layer 304 is diced over the donor substrate 300-without dicing through the donor substrate 300-to partially singulate the IC components 306 in the layer 304. In some embodiments, the release layer 302 may also be singulated (e.g., diced or etched) along with the transfer layer comprising the IC components 306.

In FIG. 3C, the donor substrate 300 is diced into singulated donor dies 301 that each contain a subset of the IC components 306 from the original donor substrate 300. For example, each donor die 301 may include one or more IC components 306 from the layer 304 on the original donor substrate 300.

In FIG. 3D, either blanket laser exposure (as shown) or a selective laser release is performed on the donor release layer 302 to weaken the entire release layer 302 prior to the transfer (e.g., using IR/UV laser exposure or thermal techniques), thus partially releasing the IC components 306 from the donor dies 301.

In FIG. 3E, a release layer 312 is optionally formed over a receiver substrate 310 (e.g., in the event the selectively transferred IC components 306 will be subsequently debonded from the receiver substrate 310 after the transfer). Next, a bonding template 314 is formed on the surface of the receiver substrate 310 (e.g., above the release layer 312, if included). The bonding template 314 includes a pattern of bonding features or adhesive areas, such as mesas, that enable specific areas of a donor die 301 to be selectively transferred to the receiver substrate 310. In various embodiments, however, any suitable surface treatments or other techniques may be used to control the level of adhesion on different areas of the receiver substrate 310 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 3F, a bond head 320 is used to pick up one of the donor dies 301 and place it face down on the receiver substrate 310 such that the target IC components 306 on the donor die 301 are aligned with the corresponding bonding mesas of bonding template 314 on the receiver substrate 310. The donor die 301 and receiver substrate 310 are then partially bonded together (e.g., die-to-wafer bond) with the target IC components 306 bonded to the receiver bonding mesas 314.

In FIG. 3G, the bond head 320 lifts up and mechanically separates the donor die 301 from the receiver substrate 310. At this point, the IC components 306 that were selectively bonded to the receiver 310 (e.g., via the bonding mesas of bonding template 314) remain on the receiver 310 and are debonded/separated from the donor die 301 (e.g., die-to-wafer debond) due to the blanket weakening of the donor release layer 302. All other IC components 306 that were not bonded to the receiver substrate 310 remain on the donor die 301.

Alternatively, in some embodiments, instead of (or in addition to) performing a blanket laser exposure in FIG. 3D, the target IC components 306 may be selectively released (e.g., as described with respect to FIG. 1F), or the donor release layer 302 and receiver bonding template 314 may be formed with materials having different bonding strengths such that the target IC components 306 will have a stronger bond to the receiver substrate 310 than the donor die 301.

In FIG. 3H and FIG. 3I, the bond head 320 steps and repeats. For example, the bond head 320 moves to a new position and repeats the process of FIG. 3F and FIG. 3G, respectively, to selectively transfer another group of IC components 306 from the donor die 301 to other areas of the receiver substrate 310.

The process may repeat in this manner until all IC components 306 on the donor die 301 have been transferred. At that point, the bond head 320 may pick up another donor die 301 and continue transferring IC components 306 from the new donor die 301 to the same or different receiver substrate 310.

After all transfers to the receiver substrate 310 are complete, the receiver 310 may be ready for continued processing, such as dielectric fill around the transferred IC components 306, planarization, selectively transferring or pick-and-place attaching additional IC dies or other IC components, via formation, formation of interconnect/metallization layers, attaching a structural substrate, debonding the receiver substrate (e.g., via the optional receiver release layer 312), and/or any other processing required for the finished product (e.g., an IC package).

Elements labeled with reference numerals in FIGS. 3A-I may be similar to those having similar reference numerals in FIGS. 1A-I. Further, it should be appreciated that the illustrated process flow for selective layer transfers is merely presented as an example and many other process variations are also possible, including, but not limited to, the process variations described throughout this disclosure.

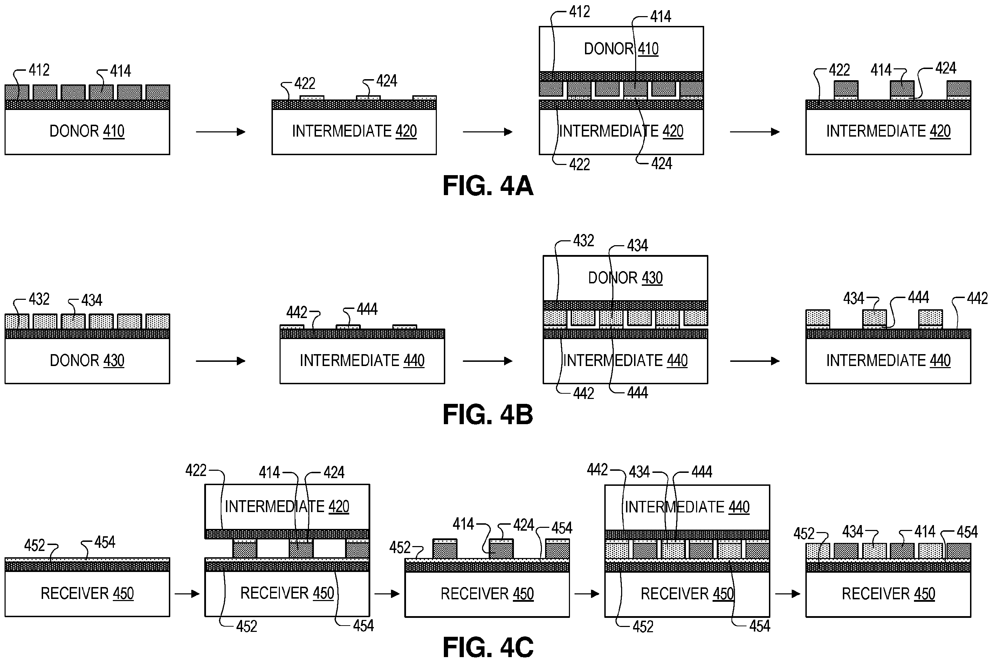

**FIGS. 4A-C** illustrate an example process flow for selective layer transfers from multiple donor substrates. In the illustrated example, integrated circuit (IC) components 414, 434 from multiple donor substrates 410, 430 are selectively transferred to a receiver substrate 450 using intermediate carrier substrates 420, 440. In some embodiments, the respective donors 410, 430 may have different types of IC components 414, 434, such as different types of IC dies or chiplets. In this manner, selective layer transfers can be used to transfer multiple types of IC components, such as different types of dies or chiplets, to the same receiver substrate 450. While the illustrated example depicts selective transfers from two types of donor substrates 410, 430 (e.g., with two types of types of IC components 414, 434), any number of donor substrates with any type of IC dies or other components are possible (including different die sizes).

In FIG. 4A, a layer of IC components 414 is selectively transferred from a first donor substrate 410 to an intermediate carrier substrate 420 (e.g., using any of the selective transfer flows described throughout the disclosure). For example, a release layer 412 is formed over the donor substrate 410. The layer 414 to be selectively transferred is then formed over the release layer 412 (e.g., by fabricating the layer 414 directly or blanket transferring the layer 414 from a wafer to the donor carrier 410) and diced into partially singulated IC components 414. Separately, a release layer 422 is formed over an intermediate carrier/receiver substrate 420, and a bonding template 424 is formed on the surface of the intermediate carrier 420 (e.g., above the release layer 422). The donor 410 and intermediate carrier 420 are then partially bonded together (e.g., with the target IC components 414 on the donor 410 bonded to the bonding features or adhesive areas 424 on the intermediate carrier 420). The donor 410 and intermediate carrier 420 are then debonded and separated from each other using any of the techniques described throughout this disclosure (e.g., selective release, blanket laser exposure, etc.). As a result, the target IC components 414 are debonded/separated from the donor 410 and remain on the intermediate carrier 420.

In FIG. 4B, another layer of IC components 434 is selectively transferred from a second donor substrate 430 to another intermediate carrier substrate 440 (e.g., using any of the selective transfer flows described throughout the disclosure). For example, a release layer 432 is formed over the donor substrate 430. The layer 434 to be selectively transferred is then formed over the release layer 432 (e.g., by fabricating the layer 434 directly or blanket transferring the layer 434 from a wafer to the donor carrier 430) and diced into partially singulated IC components 434. Separately, a release layer 442 is formed over an intermediate carrier/receiver substrate 440, and a bonding template 444 is formed on the surface of the intermediate carrier 440 (e.g., above the release layer 442). The donor 430 and intermediate carrier 440 are then partially bonded together (e.g., with the target IC components 434 on the donor 430 bonded to the bonding features or adhesive areas 444 on the intermediate carrier 440). The donor 430 and intermediate carrier 440 are then debonded and separated from each other using any of the techniques described throughout this disclosure (e.g., selective release, blanket laser exposure, etc.). As a result, the target IC components 434 are debonded/separated from the donor 430 and remain on the intermediate carrier 440.

In FIG. 4C, the IC components 414, 434 on both intermediate carriers 420, 440 are selectively transferred to a receiver substrate 450 (e.g., using any of the selective transfer flows described throughout the disclosure).

For example, a release layer 452 is optionally formed over the receiver substrate 450 (e.g., in the event the selectively transferred IC components 414, 434 will be subsequently debonded from the receiver substrate 450 after the transfer). A bonding layer 454 (e.g., with adhesive areas or bonding features) is then formed on the surface of the receiver 450 (e.g., above the release layer 452, if included). Next, the IC components 414 on the first intermediate carrier 420 are selectively transferred to the receiver substrate 450 (e.g., using any of the selective transfer flows described throughout the disclosure). Finally, the IC components 434 on the second intermediate carrier 440 are selectively transferred to the receiver substrate 450 (e.g., using any of the selective transfer flows described throughout the disclosure).

Additional processing may then be performed on the receiver substrate 450, such as cleaning steps (e.g., removing the leftover bonding structures 424, 444 from the transferred IC components 414, 434), dielectric fill around the transferred IC components 414, 434, planarization, selectively transferring or pick-and-place attaching additional IC dies or other IC components, via formation, formation of interconnect/metallization layers, attaching a structural substrate, debonding the receiver substrate (e.g., via the optional receiver release layer 452), and/or any other processing required for the finished product (e.g., an IC package).

It should be appreciated that the illustrated process flow for selective layer transfers is merely presented as an example and many other process variations are also possible, including, but not limited to, the process variations described throughout this disclosure.

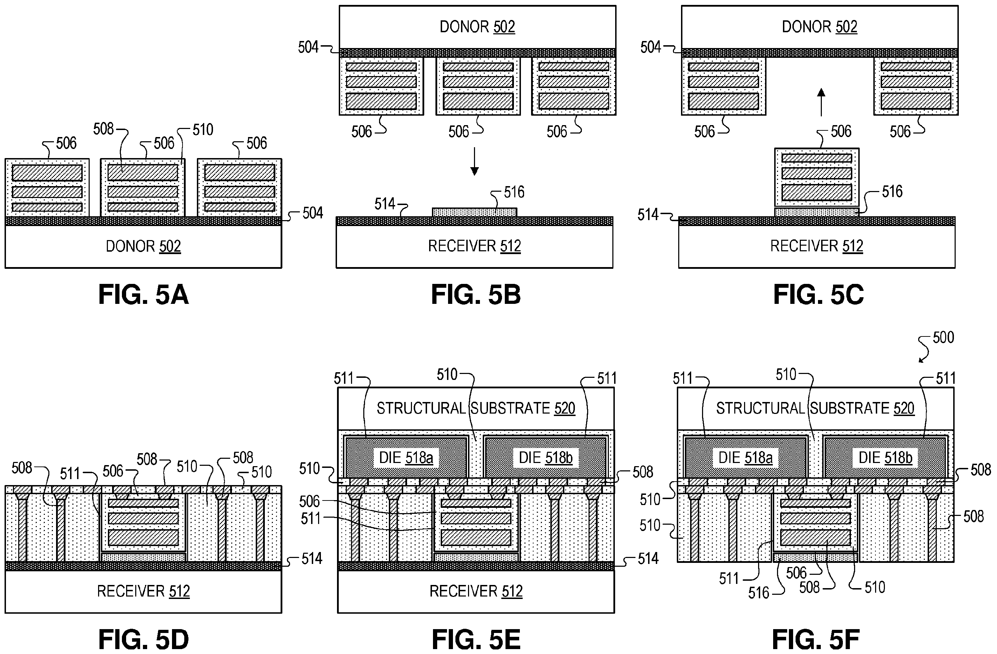

**FIGS. 5A-F** illustrate an example process flow for forming an integrated circuit (IC) package 500 with a selectively transferred passive interposer 506. Selective transfers can be used for a variety of applications, including transfers of active components (e.g., IC dies, transistors, diodes) and passive components (e.g., interconnects, metal-insulator-metal (MIM) chiplets, resistors, capacitors, inductors, transformers). In the illustrated example, the process flow is used to form an IC package 500 with a selectively-transferred low-cost passive interposer 506. For example, interposers 506 with high-density die-to-die (D2D) links 508 are created on a donor wafer 502 and then selectively transferred to a receiver wafer 512, which enables the same donor wafer 502 to be reused multiple times and amortizes the cost of the interconnect devices across multiple receiver wafers 512. In some embodiments, other components of the IC package 500 may also be selectively transferred, such as the IC dies 518a-b. Selective transfers can also be used for other applications, including, without limitation, transfers of photonic/optical components, and localized transfers of Group III-V semiconductors for radio frequency (RF) and high-power devices.

In FIG. 5A, repeated D2D interconnect patterns 506 are created on a release layer 504 of the donor substrate 502, and the resulting D2D interconnects are partially singulated (e.g., diced to, but not through, the donor substrate 502). The D2D interconnects 506 include high-density interconnect links 508 separated by dielectric layers 510.

In FIG. 5B, a transfer template 516 for a selective transfer is created on a release layer 514 of a receiver/carrier substrate 512. The transfer template 516 includes a dielectric bonding protrusion 516, referred to as a mesa, on the surface of the receiver substrate 512. In various embodiments, however, any suitable surface treatments or other techniques may be used to control the level of adhesion on different areas of the receiver substrate 512 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples. Further, in various embodiments, any number of buildup layers may be formed on the receiver substrate 512 prior to forming the templated connection pedestal or mesa 516 for the selective transfer.

The bonding mesa of the transfer template 516 is used to selectively transfer a D2D interconnect 506 from the donor 502 to the receiver 512 (e.g., using any of the selective transfer flows described throughout this disclosure). For example, the donor 502 and receiver 512 are aligned face to face, stacked, and then partially bonded together such that one of the D2D interconnects 506 on the donor 502 is bonded to the bonding mesa of the transfer template 516 on the receiver 512.

In FIG. 5C, the D2D interconnect 506 bonded to the receiver mesa of the transfer template 516 is debonded and/or released from the donor release layer 504 using any of the techniques described herein (e.g., selective release, blanket laser exposure, formation of bonds with strength disparities), and the donor 502 and receiver 512 are mechanically separated. As a result, the transferred D2D interconnect 506 is separated from the donor 502 and remains on the receiver 512.

In FIG. 5D, additional processing is performed to form the remaining interconnect, including dielectric (e.g., oxide) fill 510 and planarization, interconnect 508 patterning/metallization (e.g., formation of through-dielectric vias (TDVs), top metal contacts such as hybrid bonding pads, dielectric layers), and so forth.

Notably, since the D2D interposer 506 was selectively transferred while the surrounding dielectric layers 510 were fabricated directly on the receiver 512, there is a seam 511 between the transferred D2D interposer 506 and the surrounding layers 510, as shown in FIG. 5D. In general, this type of seam or transition may be present around selectively transferred components of any type since they are not formed contemporaneously with the surrounding layers.

In FIG. 5E, multiple IC dies 518a-b are attached to the top metal pads 508 (e.g., via hybrid bonding), the area around the dies 518a-b is filled with dielectric material 510 (e.g., oxide) and planarized, and a structural substrate 520 is attached (e.g., a structural silicon wafer).

The dies 518a-b may be attached using standard assembly techniques, such as pick and place, or using the selective transfer techniques described herein (e.g., similar to the transferred D2D interconnect 506).

If the dies 518a-b are attached using pick-and-place assembly, they are typically formed on a thick substrate for handling purposes and then subsequently thinned after the attach.

If the dies 518a-b are selectively transferred, however, they can be formed on-and transferred directly from-a very thin substrate. As a result, selectively transferring the dies 518a-b not only eliminates the need for post-attach thinning, it also enables the dies 518a-b to be much thinner than dies that are pick-and-place attached and subsequently thinned. Further, if the dies 518a-b are selectively transferred, there may be a seam 511 between the dies 518a-b and portions of the layers 510 surrounding the dies 518a-b, similar to the seam 511 shown around the transferred D2D interconnect 506, as described above. Moreover, because the dies 518a-b are selectively transferred, they can be different types of dies, formed on separate pieces of substrate material (e.g., separate wafers or panels) using separate processes, and then selectively transferred to the same layer of an IC device 500.

In FIG. 5F, the receiver 512 is debonded and released from the release layer 514 (e.g., using any of the techniques described herein, such as IR or UV laser ablation).

At this point, the IC package 500 may be complete, or alternatively, additional processing may be performed. For example, if the processing is performed at the wafer or panel level, the resulting IC packages 500 on the structural substrate 520 may be singulated.

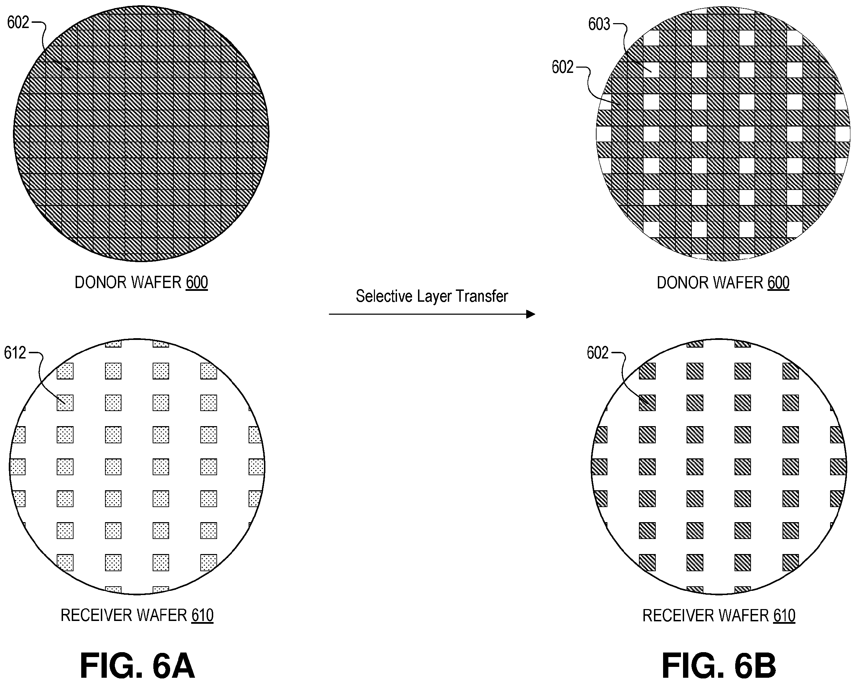

**FIGS. 6A-B** illustrate an example of a selective layer transfer between donor and receiver wafers 600, 610. In particular, FIG. 6A shows the wafers 600, 610 prior to the transfer, while FIG. 6B shows the wafers 600, 610 after the transfer. In the illustrated example, non-contiguous areas of the donor wafer 600 are selectively transferred to non-contiguous positions on the receiver wafer 610. In other embodiments, however, the target areas on the donor 600 and the destination areas on the receiver 610 may be partially contiguous or fully contiguous.

As shown in FIG. 6A, prior to the transfer, the donor wafer 600 includes a layer of integrated circuit (IC) components 602 (e.g., dies, chiplets, interconnects, capacitors, transistors, etc.), which may be partially singulated (e.g., diced down to, but not through, the underlying wafer 600). The receiver wafer 610 includes adhesive areas 612 patterned in non-contiguous positions on the surface (also referred to as a bonding template), which is where the target IC components 602 from the donor 600 will be transferred. In some embodiments, for example, the adhesive areas 612 may be raised structures or protrusions (referred to as "mesas") patterned on the surface of the receiver 612. Moreover, in some embodiments, the adhesive areas 612 on the receiver 610 may have a similar footprint as the target IC components 602 on the donor 600. In various embodiments, however, any suitable surface treatments or other techniques may be used to control the level of adhesion on different areas of the receiver substrate 610 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

As shown in FIG. 6B, after the transfer, the target IC components 602 have been transferred from the donor wafer 600 to the receiver wafer 610. As a result, the donor wafer 600 includes empty areas 603 where the transferred IC components 602 were located, while the receiver wafer 610 includes the transferred IC components 602 in the positions where the adhesive areas 612 were patterned. In particular, individual IC components 602 from the donor wafer 600 are now bonded to individual adhesive areas 612 on the receiver wafer 610.

While the illustrated example depicts a selective transfer between two wafers, selective transfers can be performed between panels or other substrates of any shape or size, including substrates with mismatched shapes and sizes.

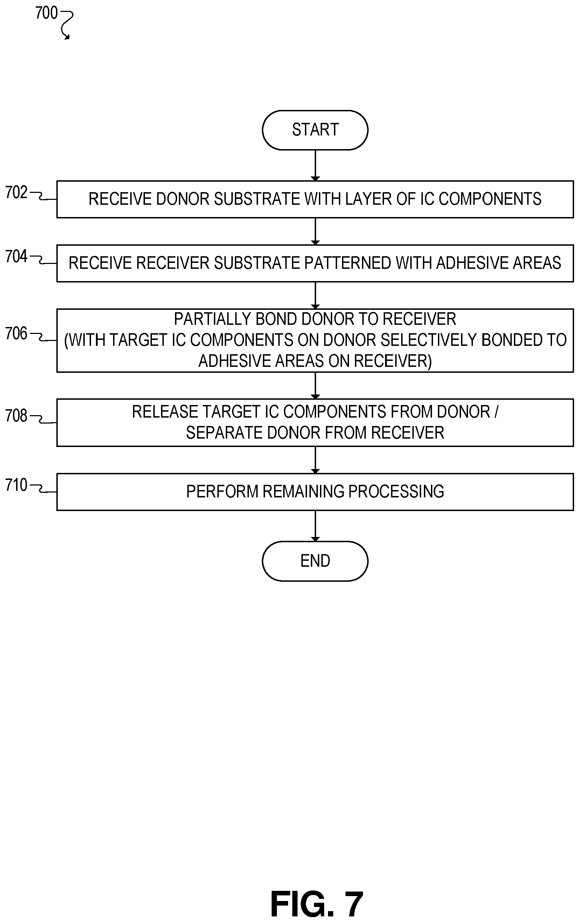

**FIG. 7** illustrates a flowchart 700 for performing selective layer transfers. It will be appreciated in light of the present disclosure that the illustrated process flow is only one example methodology for performing selective layer transfers. Moreover, the steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 702 by receiving a first substrate with a layer of integrated circuit (IC) components, which may be referred to as the donor substrate. In some embodiments, the donor substrate may include a base substrate, a release layer over the base substrate, and a (partially singulated) layer of IC components over the release layer.

In some embodiments, the donor substrate may be formed by receiving the base substrate, forming the release layer over the base substrate, forming the layer of IC components over the release layer (e.g., by fabricating or transferring the layer of IC components over the release layer), and partially singulating the layer of IC components (e.g., by dicing through the layer of IC components without dicing through the base substrate).

In various embodiments, the layer of IC components may include one or more IC dies, interconnects, transistors, diodes, resistors, capacitors, inductors, transformers, optical components, and/or any other active or passive circuitry or components.

The base substrate may be made of one or more materials that include elements such as silicon (Si), oxygen (O), carbon (C), hydrogen (H), and/or Group III-V elements (e.g., aluminum (Al), gallium (Ga), indium (In), nitrogen (N), phosphorus (P), arsenic (As), antimony (Sb)), including, without limitation, silicon (Si), silicon dioxide (silica or $SiO_2$), silicon on insulator (SOI), quartz, glass, Group III-V materials (e.g., gallium nitride (GaN), aluminum gallium nitride (GaN), gallium arsenide (GaAs), indium gallium arsenide (InGaAs), indium phosphide (InP)), and epoxies/resins (e.g., IR or UV transparent epoxies).

The release layer may include one or more layers of varying materials depending on the type of release or debonding technology used. For example, for IR laser debonding, the release layer may include one or more layers of material(s) capable of absorbing and/or reflecting infrared (IR) electromagnetic radiation, such as a thin metal layer or multiple metal layers (e.g., aluminum (Al), tungsten (W), copper (Cu), titanium (Ti), titanium nitride (TiN), tantalum (Ta), tantalum nitride (TaN)). For UV laser debonding, the release layer may include one or more layers of material(s) capable of absorbing ultraviolet (UV) electromagnetic radiation (e.g., organic polymers such as polyimides). In some embodiments, the release layer may additionally or alternatively include one or more layers of dielectric materials to buffer laser ablation and thermal energy, control thin film interference or adhesion, and/or provide residual adhesion after other materials and/or layers in the release layers are weakened, removed, and/or ablated by a laser (e.g., silicon dioxide ($SiO_2$), silicon nitride ($Si_3N_4$), silicon oxynitride (SiON), silicon carbide (SiC), silicon carbon nitride (SiCN), silicon oxycarbon nitride (SiOCN), aluminum oxide ($Al_2O_3$), low-k dielectrics such as carbon-doped oxide (CDO) or porous silicon dioxide ($SiO_2$), titanium dioxide ($TiO_2$), tantalum oxide ($Ta_2O_5$)). Thus, in some embodiments, the release layer(s) may be made of one or more materials that include elements such as aluminum (Al), tungsten (W), copper (Cu), titanium (Ti), tantalum (Ta), silicon (Si), oxygen (O), nitrogen (N), hydrogen (H), and carbon (C), including, without limitation, any of the materials referenced above.

The flowchart then proceeds to block 704 to receive a second substrate with one or more adhesive areas, which may be referred to as the receiver substrate. In some embodiments, the receiver substrate may include a base substrate patterned with one or more adhesive areas on the surface, such as a layer of raised bonding structures or "mesas" over the base substrate. The receiver substrate may also optionally include a release layer over the base substrate (e.g., to enable the base substrate to be subsequently debonded after the transfer) and/or one or more additional buildup layers and/or IC components.

In some embodiments, the receiver substrate may be formed by receiving the base substrate, optionally forming a release layer over the base substrate, optionally forming additional buildup layers and/or IC components over the base substrate (e.g., over the optional release layer, if included), and forming the adhesive areas (e.g., bonding structures) on the surface of the receiver substrate (e.g., over the previously referenced layers, if included). In some embodiments, the base substrate and the optional release layer of the receiver may be made of any of the materials referenced above for the base substrate and the release layer of the donor, respectively.

In some embodiments, the adhesive areas may include mesa structures with similar footprints as the corresponding IC components to be transferred from the donor (although, in some cases, the mesas may be slightly larger or smaller than the IC components to accommodate alignment and manufacturing tolerances). The mesa structures may be made of varying materials depending on the type of bond and/or whether electrical connections are needed through the bond interface for the subsequently bonded IC components (e.g., dielectric material, metal, or both). For example, the mesa structures may include blanket dielectric structures with no conductive contacts (e.g., for dielectric-to-dielectric bonds), dielectric structures with conductive contacts (e.g., for hybrid dielectric and metal bonds), and/or conductive contacts by themselves (e.g., for metal-to-metal bonds). Thus, in some embodiments, the mesa structures may be made of one or more materials that include elements such as silicon (Si), oxygen (O), hydrogen (H), nitrogen (N), carbon (C), aluminum (Al), tungsten (W), copper (Cu), titanium (Ti), tantalum (Ta), including, without limitation, inorganic dielectrics such as silicon dioxide ($SiO_2$), silicon nitride ($Si_3N_4$), and/or silicon carbon nitride (SiCN), organic dielectrics such as photoresists and adhesives, and/or conductive materials such as metals and alloys (e.g., any of the foregoing metal elements and/or compounds/alloys thereof).

In various embodiments, however, any suitable technique(s) may be used to control the level of adhesion on different areas of the receiver substrate. For example, a variety of surface treatments (e.g., lithographically or additively manufactured) can be used to enhance and/or reduce adhesion in select areas of the receiver substrate, including, without limitation, modifying the surface topography (e.g., raised vs. recessed areas, smooth vs. rough areas), use of materials with high and/or low adhesion (e.g., forming layers with adhesive and non-adhesive materials in select areas), treatments using hydrophobic materials and/or self-assembled monolayers (SAMs), and/or surface activation techniques (e.g., plasma or wet activation), among other examples.

For example, the surface topography of the receiver substrate may be modified (e.g., using techniques such as deposition, lithography, etching, roughening) to form areas with different levels of adhesion, such as raised (e.g., adhesive) and recessed (e.g., non-adhesive) areas, smooth (e.g., adhesive) and rough (e.g., non-adhesive) areas, etc.

As another example, the surface of the receiver substrate may be patterned with materials having high and/or low adhesion in select areas. For example, a layer patterned with different areas of adhesive and non-adhesive materials may be formed on the receiver substrate. In some embodiments, the adhesive material may include silicon dioxide ($SiO_2$) or silicon carbon nitride (SiCN) to promote strong oxide fusion bonds, silicon carbide (SiC) to provide lower thermal contact resistance compared to $SiO_2$ or SiCN, and/or metal to form electrical connections. Further, in some embodiments, the non-adhesive material may include silicon nitride ($Si_3N_4$) to form weak or no bonds.

As another example, treatments using hydrophobic materials and/or self-assembled monolayers (SAMs) may be used to enhance and/or reduce adhesion in select areas of the receiver substrate (e.g., using a SAM treatment to create monolayers with high and/or low adhesion in select areas). In some embodiments, the hydrophobic material may include a SAM material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). However, non-SAM based materials or films may also be used. In some embodiments, the hydrophobic material may include a thin polymer film such as a siloxane (e.g., PDMS and derivatives, HMDSO), a silazane (HMDS), a polyolefin (e.g., PP), or a fluorinated polymer (e.g., PTFE, PFPE, PFDA, C4F8 plasma polymerized films, etc.). Other hydrophobic materials may be used in other embodiments.

As another example, surface activation techniques may be used to enhance and/or reduce adhesion in select areas of the receiver substrate, including, without limitation, plasma or wet activation.

The flowchart then proceeds to block 706 to partially bond the donor substrate to the receiver substrate (e.g., face to face), such that one or more target IC components on the donor substrate are selectively bonded to the one or more adhesive areas on the receiver substrate. The donor and receiver substrates may be partially bonded using any suitable bonding techniques, including, without limitation, hybrid bonding, fusion bonding, and/or adhesive bonding.

The flowchart then proceeds to block 708 to release the target IC components from the donor substrate and separate the donor substrate from the receiver substrate. In this manner, when the donor and receiver substrates are separated, the target IC components are separated from the donor substrate and remain on the receiver substrate.

In some embodiments, the donor and receiver substrates may be debonded/separated from each other by releasing, at least partially, the target IC components from the release layer of the donor substrate and then mechanically separating the donor and receiver substrates. For example, in some embodiments, the target IC components may be fully released from the donor substrate by selectively debonding them from the donor release layer using a laser (e.g., an IR or UV laser), or alternatively, the target IC components may be partially released from the donor substrate by weakening the donor release layer using a laser (e.g., an IR or UV laser). After fully or partially releasing the target IC components from the donor, the donor and receiver substrates are mechanically separated, and post separation, the target IC components remain bonded to the receiver and are no longer on the donor.

Alternatively, or additionally, the donor release layer and the receiver bonding structures may be formed with respective materials that have disparate bond strengths-such that the target IC components have a stronger bond to the receiver than the donor-thus causing the target IC components to debond from the donor and remain on the receiver when the donor and receiver are mechanically separated.

The flowchart then proceeds to block 710 to perform any remaining processing, such as dielectric filling and planarization, attaching additional IC dies or components (e.g., via selective transfers or pick-and-place assembly), forming interconnects (e.g., vias, traces), attaching a structural substrate, debonding the receiver base substrate (e.g., via the optional receiver release layer), and/or any other processing required for the finished product (e.g., an IC package, device, system, etc.).

The completed product may include a variety of components and circuitry (some of which may have been selectively transferred), including electrical components (e.g., electronic integrated circuits (EICs), processors, XPUs, controllers, memory), optical components (e.g., optical interfaces, photonic integrated circuits (PICs), optical connectors, fibers), and/or radio frequency (RF) or high-voltage components (e.g., high-voltage electrostatic discharge (ESD) devices, power amplifiers (PAs), low noise amplifiers (LNAs), voltage controlled oscillators (VCOs), surface acoustic wave (SAW) / bulk acoustic wave (BAW) devices or filters, bandpass filters (BPFs), intermediate-frequency (IF) amplifiers, frequency synthesizers, mixers, RF digital-to-analog converters (DACs), RF analog-to-digital converters (ADCs), thick gate oxide devices, Group III-V devices/chiplets, passive RF devices such as interconnects, antennas, and inductors).

Further, in some embodiments, the resulting IC package or product may be electrically coupled to a circuit board and/or incorporated into an electronic device or system (e.g., with other electronic components).

At this point, the flowchart may be complete. In some embodiments, however, the flowchart may restart and/or certain blocks may be repeated. For example, in some embodiments, the flowchart may restart at block 702 to continue performing selective transfers.

*Blanket Wafer Laser Exposure For Fast Selective Transfers*

As discussed above, transfers of selective areas or dies from a donor substrate to a receiver substrate may address one or more shortcomings of existing approaches (e.g., full layer transfers, monolithic IC fabrication, chiplet pick-and-place assembly) and may enable the donor substrate to be reused multiple times. For example, a full wafer layer transfer requires removal of the unneeded areas after the transfer, which results in higher costs and lower performance. Moreover, pick-and-place die bonding has lower throughput as dies become smaller and more dies are attached, and the ability to scale down die area and thickness is limited, as dies/chiplets with certain design parameters cannot be attached using pick-and-place (e.g., high-aspect-ratio dies, sub-millimeter dies, thin dies/layers).

While selective transfers alleviate the foregoing limitations of existing approaches, they also face their own unique challenges. For example, in some cases, selective debonding (e.g., releasing only selective areas from the donor wafer using laser debond technology) can be slow, particularly as the transferred areas decrease in size (e.g., die size < 1 mm$^2$), and the percentage of the donor wafer transferred to each receiver wafer (%xfer) becomes lower.

Another challenge involves handling wafers for selective debond processing after bonding the donor and the receiver, which requires an in-plane offset between the wafers for all transfers after the first receiver wafer. Automated handling systems and front opening unified pods (FOUPs) that hold wafers during transport in a semiconductor foundry cannot accept these non-circular offset-bonded wafer pairs. Moreover, no existing equipment or tool is capable of performing selective debonding for wafer pairs, and even if one were developed, there would be no way to transfer offset-bonded wafer pairs between bonding and selective debonding tools. Solving the offset-bonded wafer problem requires integrating bonding, selective layer release, and debonding into a single tool, which is complicated and challenging and also requires developing new wafer handling robotics to handle offset-bonding wafers in the tool, which is even more challenging.

Accordingly, this disclosure presents embodiments of fast selective layer transfers using blanket wafer laser exposure, including processes, thin film architectures, and tooling. For example, thin structured films are fabricated below the selectively transferred layers or dies to enable blanket laser exposure of the full wafer to be performed only once followed by selective transfer of the areas from the donor wafer with a bond/debond process for each receiver wafer. This eliminates the slow process of selectively debonding small areas of the wafer for each transfer to a receiver wafer. Further, this solution leverages a novel bond/debond tool that eliminates any need to handle non-circular offset-bonded wafer pairs.

The described solution (e.g., one or more of the embodiments described herein) provides various advantages. For example, this solution eliminates the slow process of selectively debonding small areas of the wafer for each transfer to a receiver wafer-instead, only one blanket laser exposure is required for each donor wafer using standard laser debond tools. Selective transfer from the donor to each receiver wafer is controlled by selective bonding to patterned adhesive areas (e.g., mesas or other adhesive mechanisms) on the receiver wafer, which is a fast full-wafer process. The bond/debond tool eliminates any need for handling non-circular offset-bonded wafer pairs, as receiver wafers can be bonded to the pre-exposed donor wafer and then immediately debonded with selective transfer in the same module. Further, the thin film release layer architecture can be designed to protect die edge and corners from shockwave damage.

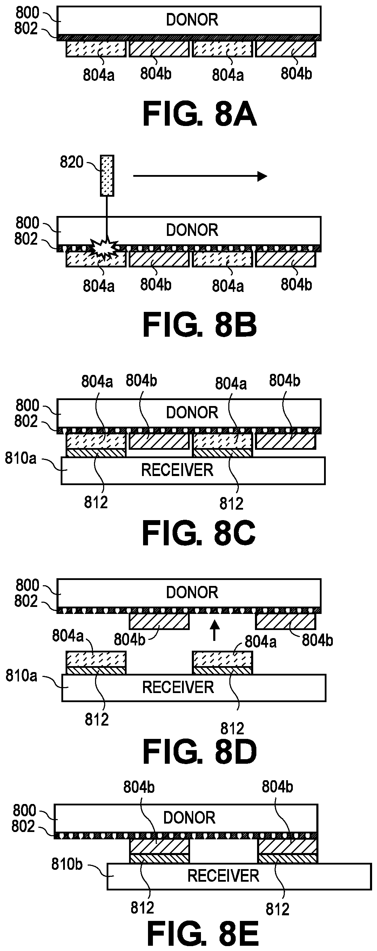

**FIGS. 8A-E** illustrate an example process flow for selective transfers using blanket wafer laser exposure. In the illustrated example, blanket laser exposure of the donor wafer 800 is performed once (e.g., in a standard laser debond tool) to weaken the release layer 802, followed by a selective bond/debond of the donor and receiver wafers 800, 810).

In FIG. 8A, a donor wafer 800 is formed with portions 804a-b of a selective transfer layer on a release layer 802. The release layer 802 may include one or more thin film layers that enable laser debonding of the portions 804a-b, such as a thin metal layer capable of absorbing infrared (IR) light, and/or structured dielectric and metal layers. In FIGS. 8A-E, a continuous blanket release layer 802 is shown, but in other embodiments, the release layer 802 may include multiple dielectric and metal layers patterned with "street patterns" etched through some or all of those layers between the areas 804a-b to be selectively transferred.

The portions 804a-b of selective transfer layer may include any combination of one or more layers to be selectively transferred. In the illustrated example, the portions 804a-b include multiple IC components, such as dies or chiplets, that will be transferred to two different receiver wafers 810a-b across two selective transfers (e.g., %xfer = 50% per transfer). In particular, a first set of IC components (e.g., portion 804a) will be transferred to a first receiver 810a, and a second set of IC components (e.g., portion 804b) will be transferred to a second receiver 810b. In some embodiments, for example, the two sets of IC components (e.g., portions 804a-b) may be the same type of die, or different types of dies, transferred to different receivers 810a-b via separate transfers.

In FIG. 8B, a blanket scan with laser exposure is performed on the donor wafer 800 using a laser debond tool 820, which removes portions of the release layer 802 and/or weakens its structural integrity, while still providing residual adhesion to the dies/layers 804a-b that will be selectively transferred.

In FIG. 8C, the donor wafer 800 is partially or selectively bonded to a first receiver wafer 810a with templated adhesive areas 812 on its surface (e.g., using a bond/debond tool). For example, the target IC components 804a for the first transfer from the donor 810a are bonded to the adhesive areas 812 on the receiver 810a, while the other IC components 804b remain unbonded. In the illustrated embodiment, the adhesive areas 812 are raised bonding mesas. In other embodiments, however, the adhesive areas 812 may be formed using any suitable surface treatments or other techniques to control the level of adhesion in different areas of the receiver substrates 810a-b, including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 8D, the donor and receiver wafers 800, 810a are mechanically separated and debonded. In particular, due to the weakened release layer 802, when the donor and receiver wafers 800, 810a are mechanically separated, the target IC components 804a are debonded from the donor 800 and remain on the receiver 810a. This is because the bond to the receiver 810a is stronger than the residual adhesion to the donor 800, as the bond energy provided by the mesas 812 is greater than the residual adhesion energy provided by the weakened release layer 802.

In FIG. 8E, the first receiver wafer 810a is transferred out and a second receiver wafer 810b is transferred in for the next selective transfer, and the steps of FIG. 8C and FIG. 8D are repeated to transfer another set of IC components 804b to the new receiver 810b (e.g., by selectively bonding/debonding the donor 800 and receiver 810b). The steps of FIG. 8C and FIG. 8D may be repeated in this manner for as many receiver wafers 810 as needed.

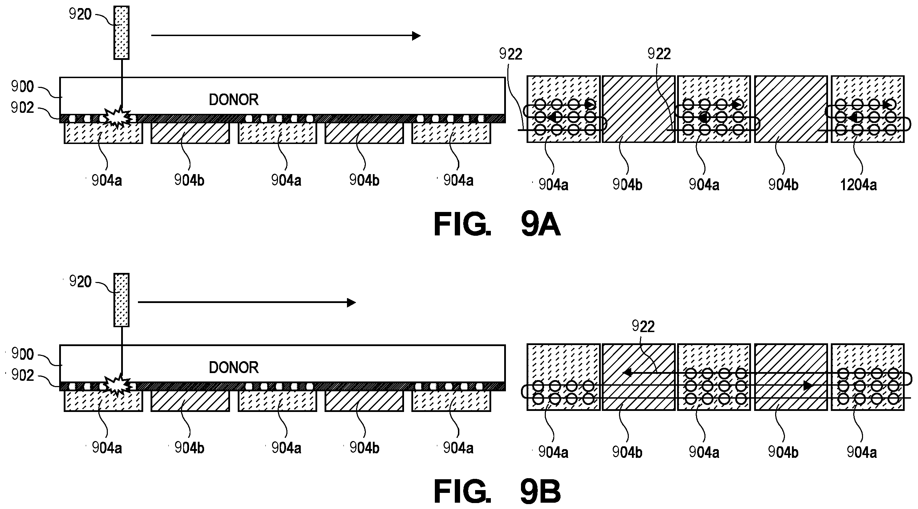

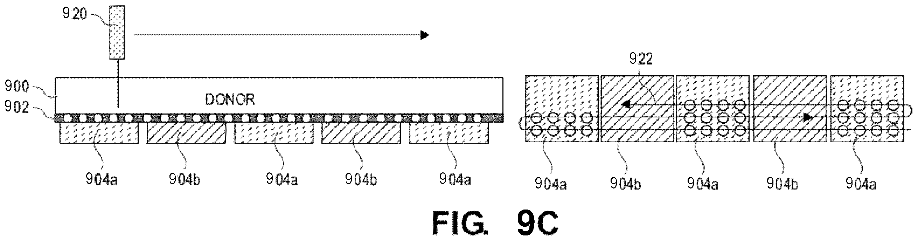

**FIGS. 9A-C** illustrate various laser release techniques for selective transfers. In particular, FIGS. 9A, 9B, and 9C depict cross-section and plan views of a donor wafer 900 while performing selective scan and laser exposure, blanket scan and selective laser exposure, and blanket scan and laser exposure techniques, respectively.

In the illustrated examples, the various laser release techniques are performed on a donor wafer 900 with a layer of integrated circuit (IC) dies 904a-b over a release layer 902.

In FIG. 9A, the laser release is performed using a selective scan and laser exposure technique. As depicted by the laser path 922, the donor wafer 900 is selectively scanned and exposed to the laser 920 (e.g., using a galvanometer) over the areas of the release layer 902 that are bonded to the target dies 904a to be transferred, thus removing or weakening those areas of the release layer 902 for the subsequent transfer. This approach is relatively slow, as it has a very short scan length and requires numerous direction changes per die 904a, with each direction change taking, e.g., approximately 1 millisecond (ms), and many steppings between the selective release areas. As a result, the average scanning speed gets slower as the dies 904a-b become smaller. Moreover, this selective release process must be repeated on the donor wafer 900 for each transfer to a receiver wafer. This approach also requires complicated integration of bonding, selective laser release, and debonding with transfer of offset-bonded wafer pairs.

In FIG. 9B, the laser release is performed using a blanket scan and selective laser exposure technique. As depicted by the laser path 922, the entire donor wafer 900 is blanket scanned but only selectively exposed to the laser 920 over areas of the release layer 902 that are bonded to the target dies 904a. For example, during the blanket scan, the laser 920 may be exposed while scanning over the target dies 904a and shuttered while scanning over the unselected dies 904b. This approach is faster than the one from FIG. 9A, as fewer direction changes are required since the entire donor wafer 900 is scanned. However, even though the entire donor wafer 900 is scanned, only the target dies 904a are released during the scan. As a result, this approach requires a full donor wafer scan for each transfer to a receiver wafer. The transfer time per die for this approach can be computed as follows: *transfer time per die* =

$$\frac{blanket\ exposure\ time}{\%xfer}$$, where '%xfer' represents the percentage of dies (or other selectively transferred components) on the donor wafer that are transferred to each receiver wafer. The transfer time per die increases as the transfer percentage (%xfer) decreases. For example, if only 1 out of every 10 dies on the donor are transferred each time, the transfer percentage (%xfer) is 10%, which increases the transfer time per die since more transfers are required. This approach also requires complicated integration of bonding, selective laser release, and debonding with transfer of offset-bonded wafer pairs.

In FIG. 9C, the laser release is performed using a blanket scan and laser exposure technique. As depicted by the laser path 922, the entire donor wafer 900 is blanket scanned and exposed to the laser 920, thus weakening the entire release layer 902 while still providing residual adhesion to the dies 904a-b. In this manner, only one blanket wafer scan/exposure is required for each donor wafer 900. As a result, this approach is significantly faster than those of FIGS. 9A-B. As an example, for a die size of 1 mm$^2$, this approach may take approximately 3.6 ms per die. The laser release can be performed using standard laser debond tooling, while the subsequent bond/debond with receiver wafers can be performed using a bond/debond tool which provides a much simpler configuration compared to the other approaches and does not require offset-bonded wafer handling.

*Structural Support Layer to Protect Selective Transfer Layer During Laser Exposure of Unbonded Wafers*

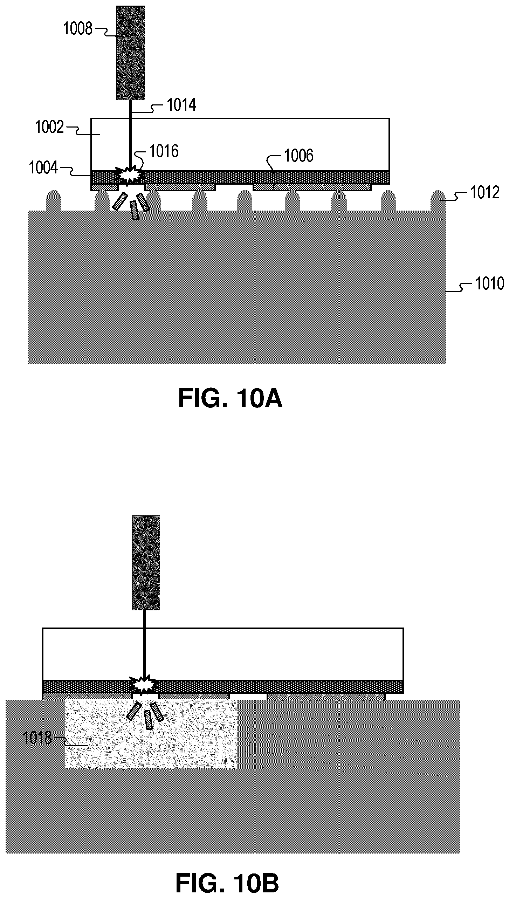

**FIGS. 10A-B** illustrate laser debonding techniques that put selective transfer layers at risk of damage. In FIG. 10A, donor substrate 1002 with a release layer 1004 and a selective transfer layer 1006 is placed in contact with a chuck 1010 of a laser debond tool. The chuck 1010 includes a plurality of micropillars 1012 that extend upwards from the main body of the chuck 1010 and have rounded edges to reduce the area of the chuck that is in contact with the selective transfer layer 1006 during the laser debond process. The vacuum chuck may function to hold the wafer flat and stable, allowing the laser 1008 to accurately focus its beam 1014.

During a laser exposure process, laser 1008 may apply beam 1014 to the release layer 1004 to weaken the layer prior to selective transfer of portions of the selective transfer layer 1006. In particular areas, the laser induced ablation pressure and other stresses may crack or even blast holes in the selective transfer layer 1006 due to insufficient support from the chuck 1010 (e.g., in areas between adjacent micropillars).

Even for a flat chuck design that omits the micropillars as shown in FIG. 10B, millimeter (mm)-scale (e.g., 1-3 mm wide) vacuum ports 1018 may result in areas where the selective transfer layer 1006 is unsupported (as the diameter of the laser spot is much smaller, e.g., ~ 20-100 um). Again, the laser induced ablation pressure and other stresses during the laser exposure process may result in cracking or more severe damage to the selective transfer layer in the areas that are not supported. Moreover, the vacuum of the laser debond tool may also cause local stresses.

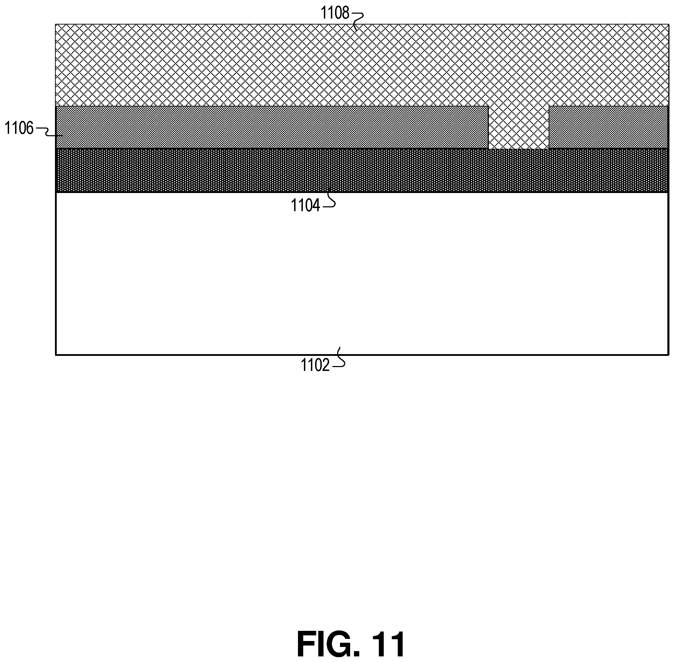

**FIG. 11** illustrates an example structural support layer 1108 to protect a selective transfer layer 1106. As depicted, a release layer 1104 is formed on a donor substrate 1102. The selective transfer layer 1106 is formed over (e.g., on) the release layer 1104, and the structural support layer 1108 is formed over (e.g., on) the selective transfer layer 1106.

Various embodiments of the present disclosure include the addition of structural support (e.g., structural support layer 1108) above thin layers or dies (e.g., of the selective transfer layer 1106) to protect the thin layers or dies during laser exposure. The structural support layer 1108 may also provide surface protection when it contacts a chuck of a laser debond tool, preventing the selective transfer layer 1106 from being contaminated by contact with metals of the chuck or other contaminants.

In some embodiments, the structural support layer 1108 is a temporary support layer deposited on the top of the donor substrate (e.g., wafer) over the selective transfer layer 1106. For example, the structural support layer 1108 may be removed after the laser exposure process is complete (e.g., through etching) and before the selective transfer layer 1106 is selectively transferred to one or more receiver substrates. In other embodiments, the structural support layer 1108 may be kept intact during the selective transfers to the receiver substrates (e.g., vias may be formed through the structural support layer 1108 for desired connectivity) and subsequent processing.

In various embodiments, the structural support layer 1108 is thicker than the selective transfer layer 1106 in order to provide sufficient support to prevent against flexing and fracturing of the selective transfer layer 1106 during laser exposure. In various examples, the structural support layer 1108 may be greater than 1.5x, 2x, 3x, or 5x the thickness of the selective transfer layer 1106. In some embodiments, the structural support layer 1108 has a thickness within the range of ~1 micron to -100 microns, whereas the selective transfer layer 1106 has a thickness in the range of ~100 nanometers to ~1 micron) (other suitable thicknesses are contemplated herein).

In some examples, the structural support layer 1108 is an inorganic thin film, such as a dielectric deposited (e.g., via plasma-enhanced chemical vapor deposition (PECVD)) on the selective transfer layer 1106. For example, the structural support layer 1108 may comprise oxygen, silicon, carbon, and/or nitrogen. For example, the structural support layer 1108 may comprise an oxide, such as silicon dioxide (e.g., $SiO_2$), or a nitride, such as silicon nitride (e.g., $SiN_x$), silicon carbon nitride (e.g., SiCN), silicon oxynitride (e.g., SiON), or silicon oxycarbonitride (e.g., SiOCN). In other examples, the structural support layer 1108 is a spin-on organic layer, such as a photoresist. In various examples, the photoresist can be positive tone or negative tone, single component, e.g., polymethylemethacrylate (PMMA), or multicomponent, e.g., phenol-formaldehyde/diazonaphthaquinone (Novolak/DNQ), or any other photoresist formulation. The structural support layer 1108 may comprise other suitable spin-on organic layers, such as silica-filled spin-on dielectric or any other spin-on organic layer. In yet other embodiments, the structural support layer 1108 may comprise an adhesive (e.g., a light release adhesive) and a layer comprising glass. Other suitable organic or inorganic dielectrics may be used for the structural support layer 1108.

For purposes of this disclosure, the term structural support layer may be used to refer to one or more physical layers formed over one or more other (e.g., thin) layers (e.g., a selective transfer layer), such as an individual layer of material, or a stack of multiple layers of one or more materials.

In some embodiments, the structural support layer comprises two different film layers. For example, a first film layer may be suitable for gap fill (e.g., to fill the space between discrete portions of the selective transfer layer 1106) or may be part of the fabrication of the selective transfer layer while a second film layer placed over the first film layer may be suitable for structural support and/or device protection functions. In some embodiments, the second layer may be lower cost or easier to remove than the first layer and thus may be readily applied with greater volume than the first layer. Thus, in some examples, the second layer may be thicker than the first layer.

In the embodiment depicted, the structural support layer 1108 completely fills the gap (e.g., where the gap may be created via singulation or other process) in between two adjacent portions of selective transfer layer 1106. In other examples, a small void may exist within the gap where the fill is incomplete, but such a void may be relatively small compared to the width of the gap and/or die thickness in order to maintain sufficient strength within the structural support layer 1108 to protect the selective transfer layer 1106.

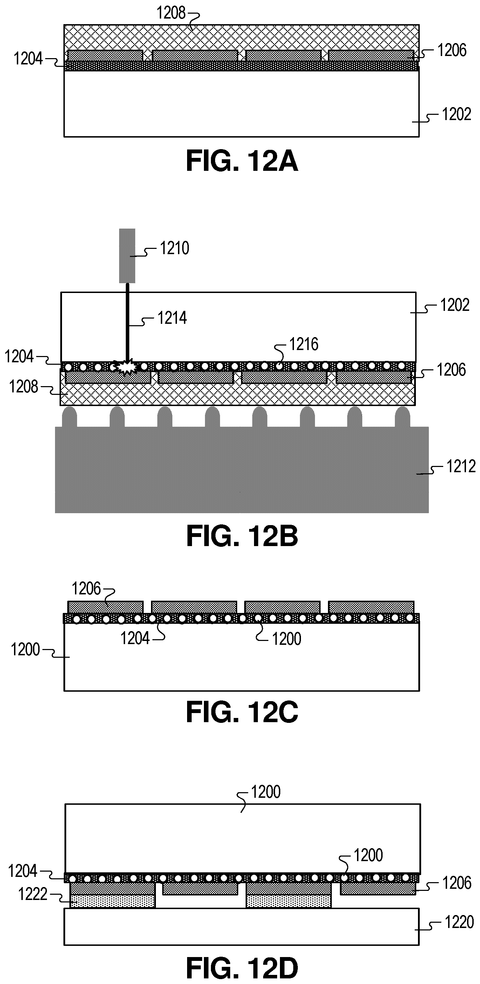

**FIGS. 12A-D** illustrate an example process flow for selective layer transfers using a structural support layer.

FIG. 12A depicts a donor substrate 1202, a release layer 1204 formed on the donor substrate 1202, a selective transfer layer 1206 formed on the release layer 1204, and a structural support layer 1208 formed on the selective transfer layer 1206. In the gaps between discrete portions of the selective transfer layer 1206, the structural support layer may be formed on the release layer 1204 and in between discrete portions of the selective transfer layer. In various embodiments, the structural support layer 1208 may be formed on the selective transfer layer 1206 using any suitable deposition techniques.

FIG. 12B illustrates laser exposure (e.g., which may be performed in a manner described above in connection with any of FIGS. 9A-9C or via other suitable manner) of the donor substrate 1202 in a laser debond tool with a chuck 1212. The structural support layer 1208 is placed in contact with the chuck 1212 (e.g., it may rest on micropillars of the chuck 1212). At this stage, the donor substrate 1202 is inverted and placed in a laser debond tool comprising a laser and the chuck 1212. A laser 1210 applies a laser beam 1214 to various locations of the release layer 1204 resulting in the creation of apertures 1216 (or at least weakened areas within the release layer 1204). During the laser exposure, the structural support layer 1208 provides support to the selective transfer layer 1206 to protect against cracking and breakage due to the laser exposure process.

In FIG. 12C, the donor substrate 1202 is removed from the laser debond tool and the structural support layer 1208 is removed. For example, the structural support layer 1208 may be etched away (e.g., via a dry etch).

In FIG. 12D, portions of the selective transfer layer 1206 (which are now exposed after removal of the structural support layer 1208) are transferred to a receiver substrate 1220. For example, the portions of the selective transfer layer 1206 that are transferred may be placed in contact with bonding features 1222 (e.g., templated mesas) formed on the receiver substrate 1220. The selective transfer may be performed according to any suitable embodiments described herein.

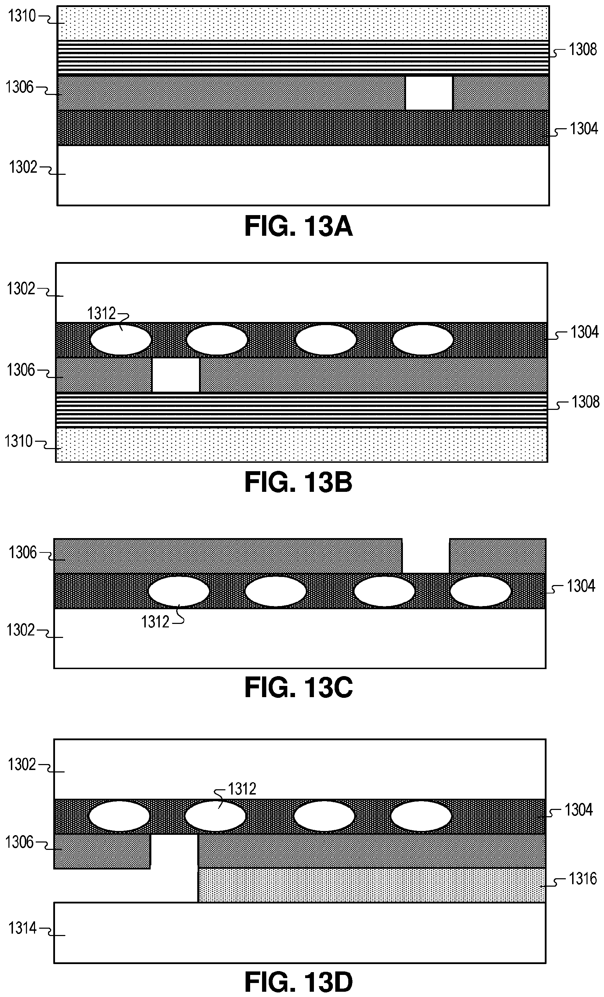

**FIGS. 13A-D** illustrate an example process flow for selective layer transfers using a structural support layer comprising glass and a light release adhesive.

In FIG. 13A, a release layer 1304 is formed on a donor substrate 1302. A selective transfer layer 1306 is formed over the release layer 1304. A structural support layer comprising an adhesive layer 1308 (e.g., a light release adhesive layer) and a glass layer 1310 (e.g., a layer predominately or substantially comprising glass) is formed over the selective transfer layer 1306.

FIG. 13B illustrates the result after the donor substrate 1302 is inverted, placed in a laser debond tool, and exposed to a laser. The application of the laser results in apertures 1312 (or other weakened areas) within the release layer 1304. During application of the laser, the adhesive layer 1308 in combination with the glass layer 1310 provides support to the selective transfer layer 1306, preventing against cracking and breakage in this layer.

FIG. 13C illustrates the result after the adhesive layer 1308 and glass layer 1310 have been removed. In one example, in order to remove the adhesive layer 1308 and the glass layer 1310, a light source (e.g., a broadband light source) may be applied to the adhesive layer 1308 to weaken the bond energy between the adhesive layer 1308 and the selective transfer layer 1306, and then the adhesive layer 1308 and the glass layer 1310 are peeled away from the selective transfer layer 1306. In various examples, before the adhesive layer 1308 and glass layer 1310 are removed (e.g., after application of the light source), the bond energy at the interface between the adhesive layer and the selective transfer layer 1306 is lower than the bond energy at the interface between the release layer 1304 and the donor substrate 1302 (such that peeling of the adhesive layer does not compromise the attachment of the selective transfer layer 1306 to the donor substrate 1302 prior to selective transfer of portions of the selective transfer layer 1306 to one or more receiver substrates).

In FIG. 13D, portions of the selective transfer layer 1306 (which are now exposed after removal of the adhesive layer 1308 and glass layer 1310) are transferred to a receiver substrate 1314. For example, the portions of the selective transfer layer 1306 that are transferred may be placed in contact with bonding features 1316 (e.g., templated mesas) formed on the receiver substrate 1314. The selective transfer may be performed according to any suitable embodiments described herein.

In some embodiments, after the selective transfer has been performed, trace amounts (or larger amounts if the structural support layer is permanent) of residue of the structural support layer may be present at or proximate the interface between the bonding feature 1316 and the selective transfer layer 1306. For example, portions of the structural support layer 1108 may be present at or proximate the interface. In some embodiments, the residue may include organic materials comprising carbon (e.g., left over from a layer comprising a photoresist or an adhesive) or hydrogen. In other embodiments, the residue may include oxygen (e.g., left over from a layer comprising an oxide) or nitrogen (e.g., left over from a layer comprising a nitride). In some embodiments, the interface where the selective transfer layer contacts the bonding features may not have the residue, but residue may be present on the side of the portion of the selective transfer layer that is transferred to the receiver substrate (e.g., within an area that corresponds to a gap between discrete portions of the selective transfer layer when the selective transfer layer is on the donor substrate).

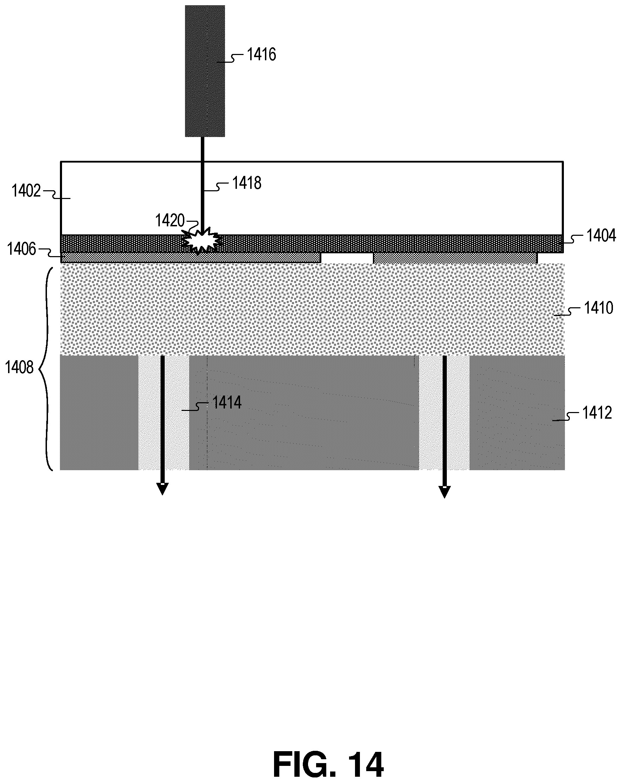

FIG. 14 illustrates an example wafer chuck 1408 with a porous portion 1410 having small pores relative to a laser spot size. In this embodiment, the porous portion 1410 interfaces with (e.g., may contact) a selective transfer layer 1406 formed on a donor substrate 1402 with a release layer 1404 and may provide structural support to the selective transfer layer 1406 during application of the laser 1416. In some embodiments, this may alleviate the need for a structural support layer over the selective transfer layer on the donor substrate.

The wafer chuck 1408 may also include a main portion 1412 and vacuum ports 1414. Although shown as simply a cavity, the cavity (e.g., a via hole) may extend to a manifold with a path to a vacuum line. The porous portion 1410 may be over the vacuum ports 1414 so as not to leave relatively large portions of the selective transfer layer 1406 unsupported during laser debonding. Thus, the stress on the relatively thin selective transfer layer 1406 may be limited to a compressive stress, protecting the selective transfer layer 1406 from breakage due to the laser.

In some instances, the chuck 1408 may be integrated with or attached to a laser debond tool that also includes laser 1416. The porous portion 1410 and/or the main portion 1412 may comprise any suitable material, such as a ceramic material, aluminum, glass, brass, bronze, stainless steel, or copper. The porous portion 1410 and/or the main portion 1412 may be the same material(s) or may comprise different materials. In one embodiment, the porous portion 1410 comprises a ceramic material.

In various embodiments the average pore size (e.g., the average diameter of the pores) of the porous portion 1410 may be smaller (e.g., much smaller) than the diameter of the spot size of the laser 1416 (e.g., the width of the aperture 1420 or otherwise weakened area within the release layer 1404 due to the laser exposure). In some examples, the average pore size of the porous portion 1410 may be less than 1/10 of the spot size of the laser 1416 to provide adequate support to the selective transfer layer 1406. In various examples, the spot size of the laser 1416 may be between ~20 and -100 microns while the average pore size of the porous portion 1410 may be less than 5 microns, less than 3 microns, less than 1 micron, etc.

The vacuum ports 1414 in combination with the porous portion 1410 (which may also allow vacuum suction to be applied due to its porosity) provide a suction force to hold the donor substrate 1402 stable as the laser is applied.

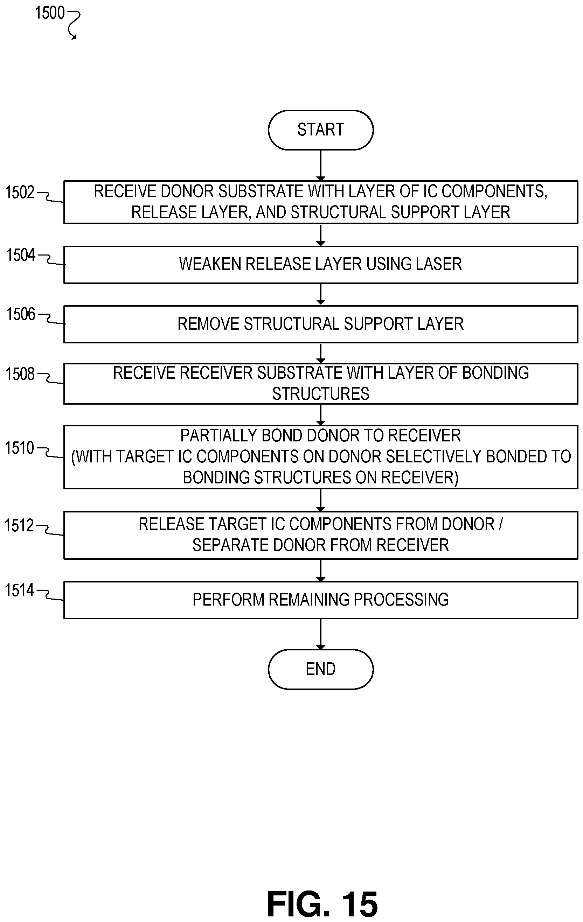

FIG. 15 illustrates a flowchart for performing selective layer transfers using a structural support layer. It will be appreciated in light of the present disclosure that the illustrated process flow is only one example methodology for performing selective layer transfers. Moreover, the steps of the illustrated process flow may be performed using any suitable semiconductor fabrication techniques such as those described herein or other suitable techniques.

The flowchart begins at block 1502 by receiving a first substrate (e.g., a donor substrate) with a layer of integrated circuit (IC) components (e.g., a selective transfer layer), a release layer, and a structural support layer. In some embodiments, one or more layers may be formed on the donor substrate (e.g., a release layer over the donor substrate, a layer of IC components over the release layer, and a structural support layer over the layer of IC components).

In some embodiments, the donor substrate with the layer of IC components may be formed by receiving the donor substrate, forming the release layer over the donor substrate, forming the layer of IC components over the release layer (e.g., by fabricating or transferring the layer of IC components over the release layer), partially singulating the layer of IC components (e.g., by dicing through the layer of IC components without dicing through the donor substrate), and/or forming the structural support layer over the layer of IC components.

In various embodiments, the layer of IC components may include one or more IC dies, interconnects, transistors, diodes, resistors, capacitors, inductors, transformers, optical components, and/or any other active or passive circuitry or other components (e.g., as described herein).

The donor substrate and its layers may be made of one or more materials such as those described above in connection with FIG. 7 or other suitable materials.

The flowchart then proceeds to block 1504, where the release layer is weakened using a laser. For example, laser exposure may be applied using any of the techniques described herein (e.g., in connection with FIGs. 9A-9C) or other suitable techniques.

The flowchart then proceeds to block 1506, where the structural support layer is removed. The removal process may be dependent on the type of material(s) included in the structural support layer. In one embodiment, the structural support layer is removed by applying one or more etch materials. In another embodiment (for example when the structural support layer includes an adhesive), the structural support layer is exposed to a light source (e.g., a broadband light source) to weaken its bond strength and then the adhesive and other material (e.g., glass) of the structural support layer is peeled off. In other embodiments where the structural support layer is to remain on the layer of IC components during the selective transfer process, this operation may be omitted.

The flowchart then proceeds to block 1508 to receive a second substrate (which may be referred to as the receiver substrate) with a layer of one or more bonding structures. In some embodiments, a layer of bonding structures (e.g., adhesive areas) may be formed on the surface of the receiver substrate and/or the bonding structures may extend upward from the receiver substrate. A release layer may optionally be formed over the receiver substrate (e.g., to enable the receiver substrate to be subsequently debonded after the transfer) and/or one or more additional buildup layers and/or IC components.

In some embodiments, the receiver substrate with the layer of bonding structures may be formed by receiving the receiver substrate, optionally forming a release layer over the receiver substrate, optionally forming additional buildup layers and/or IC components over the receiver substrate (e.g., over the optional release layer, if included), and forming the layer of bonding structures on the surface of the receiver substrate (e.g., over the previously referenced layers, if included).

In some embodiments, the bonding structures may include adhesive areas and/or mesa structures with similar footprints as the corresponding IC components to be transferred from the donor. The bonding structures may be made of varying materials or have any suitable characteristics, such as those described herein (e.g., in connection with FIG. 7).

In some embodiments, the receiver substrate and the optional release layer over the receiver substrate may be made of any of the materials referenced above (e.g., for the donor substrate and the release layer).

The flowchart then proceeds to block 1510 to partially bond the donor substrate to the receiver substrate (e.g., face to face), such that one or more target IC components on the donor substrate are selectively bonded to the one or more bonding structures on the receiver substrate. The donor and receiver substrates may be partially bonded using any suitable bonding techniques, including, without limitation, hybrid bonding, fusion bonding, and/or adhesive bonding.

The flowchart then proceeds to block 1512 to release the target IC components from the donor substrate and separate the donor substrate from the receiver substrate. When the donor and receiver substrates are separated, the target IC components are separated from the donor substrate and remain on the receiver substrate.

In some examples, the donor release layer and the receiver bonding structures may be formed with respective materials that have disparate bond strengths-such that the target IC components have a stronger bond to the receiver than the donor-thus causing the target IC components to debond from the donor and remain on the receiver when the donor and receiver are mechanically separated.

The flowchart then proceeds to block 1514 to perform any remaining processing, such as dielectric filling and planarization, attaching additional IC dies or components (e.g., via selective transfers or pick-and-place assembly), forming interconnects (e.g., vias, traces), attaching a structural substrate, debonding the receiver substrate (e.g., via the optional receiver release layer), and/or any other processing required for the finished product (e.g., an IC package, device, system, etc.).

The completed product may include a variety of components and circuitry (some of which may have been selectively transferred), including any of the components and circuitry described above in connection with FIG. 7 or other suitable components or circuitry.

Further, in some embodiments, the resulting IC package or product may be electrically coupled to a circuit board and/or incorporated into an electronic device or system (e.g., with other electronic components).

At this point, the flowchart may be complete. In some embodiments, however, the flowchart may restart and/or certain blocks may be repeated. For example, in some embodiments, the flowchart may restart at block 1502 to continue performing selective transfers or move to block 1520 for a different receiver substrate.

*Protective Debonding Stack for Selective Transfer Layer*

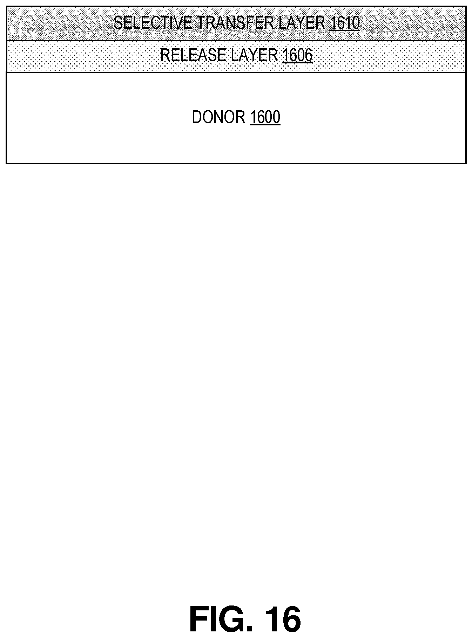

**FIG. 16** illustrates a debonding stack on a donor substrate 1600. In the embodiment depicted, release layer 1606 and selective transfer layer 1610 are formed on the donor substrate 1600.

During a selective transfer process, as part of the release process of the selective transfer layer 1610 from the donor substrate 1600, a light source (e.g., an infrared (IR) laser) may locally ablate the release layer 1606 to create a cleave plane, facilitating release of one or more portions of the selective transfer layer 1610 onto a receiver substrate. However, application of the light source risks damaging the selective transfer layer 1610 in the regions where it is unsupported by bonding to the receiver substrate. For example, localized ablation may create pressure or a shock wave that can induce local cracking of the selective transfer layer 1610 and induce mechanical damage.

Various embodiments of the present disclosure provide protective debonding stacks that include one or more protective layers that arrest or suppress cracks before they reach the selective transfer layer. Such stacks lower the risk of mechanical damage to the selective transfer layer and improve the stability of the debonding process. In various embodiments, a protective layer may prevent cracking of the selective transfer layer during a blanket IR exposure process, where there are thin film layers that are unsupported during the blanket IR exposure. In various embodiments, the protective layer(s) is placed between the release layer and the selective transfer layer.

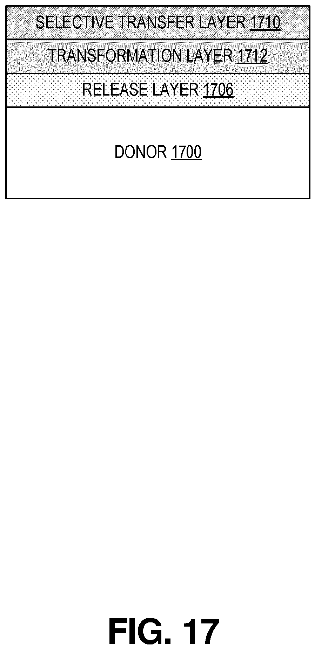

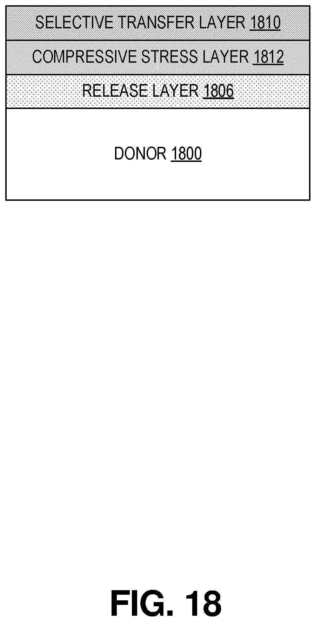

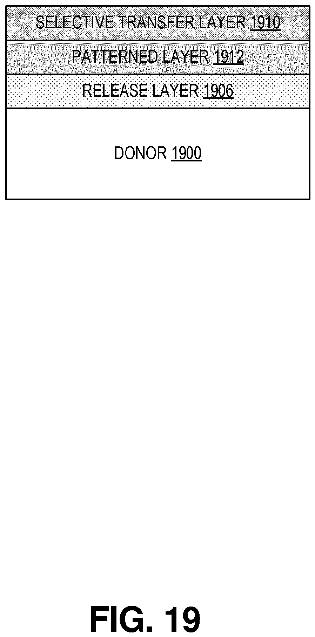

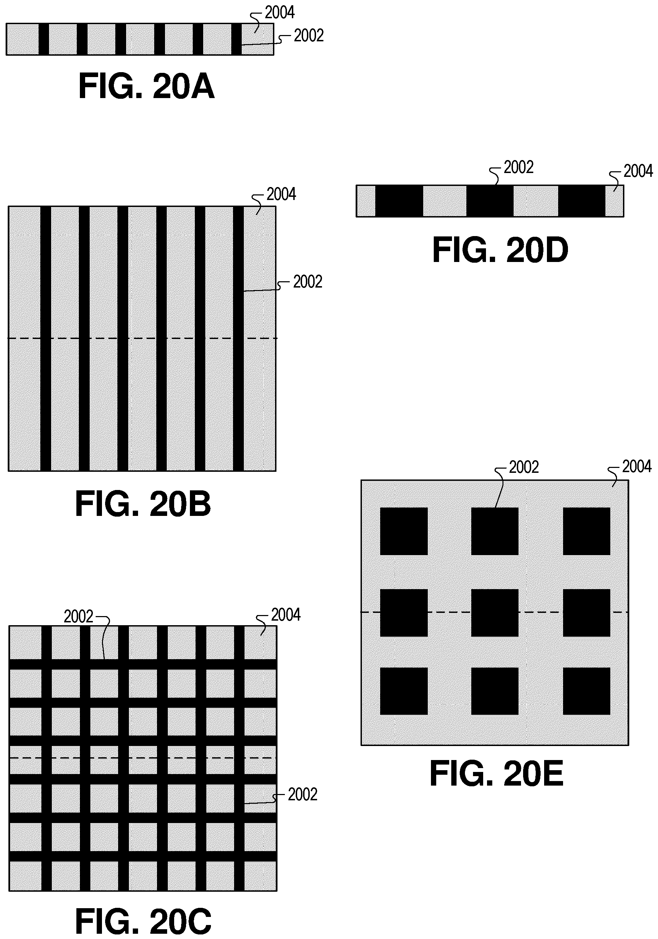

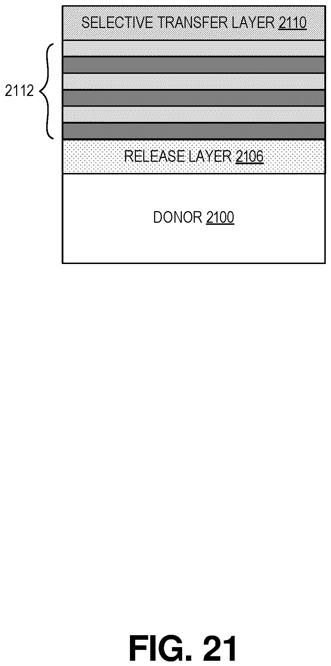

A protective layer may take any of various forms. In subsequent figures, the protective layer is illustrated in various different configurations, including a transformation layer (e.g., in FIG. 17), a compressive stress layer (e.g., in FIG. 18), a patterned layer (e.g., in FIG. 19 and 20A-E), and a reflector stack (e.g., in FIG. 21). Any of these layers may provide protection to the selective transfer layer against cracking due to stress induced by the application of the laser during ablation of the release layer 1606.

The release layer 1606 may include one or more layers of varying materials depending on the type of release or debonding technology used. For example, for IR laser debonding, the release layer may include one or more layers of material(s) capable of absorbing and/or reflecting infrared (IR) electromagnetic radiation, such as a thin metal layer or multiple metal layers (e.g., aluminum (Al), tungsten (W), copper (Cu), titanium (Ti), titanium nitride (TiN), tantalum (Ta), tantalum nitride (TaN)). For UV laser debonding, the release layer may include one or more layers of material(s) capable of absorbing ultraviolet (UV) electromagnetic radiation (e.g., organic polymers such as polyimides). In some embodiments, the release layer may additionally or alternatively include one or more layers of dielectric materials to buffer laser ablation and thermal energy, control thin film interference or adhesion, and/or provide residual adhesion after other materials and/or layers in the release layers are weakened, removed, and/or ablated by a laser (e.g., silicon dioxide ($SiO_2$), silicon nitride ($Si_3N_4$), silicon oxynitride (SiON), silicon carbide (SiC), silicon carbon nitride (SiCN), silicon oxycarbon nitride (SiOCN), aluminum oxide ($Al_2O_3$), low-k dielectrics such as carbon-doped oxide (CDO) or porous silicon dioxide ($SiO_2$), titanium dioxide ($TiO_2$), tantalum oxide ($Ta_2O_5$)). Thus, in some embodiments, the release layer(s) may be made of one or more materials that include elements such as aluminum (Al), tungsten (W), copper (Cu), titanium (Ti), tantalum (Ta), silicon (Si), oxygen (O), nitrogen (N), hydrogen (H), and carbon (C), including, without limitation, any of the materials referenced above. In various embodiments, the release layer 1606 may comprise any of the materials described in other release layers described herein (e.g., 102, 112).

The selective transfer layer 1610 may be formed above the other layers. When the selective transfer layer 1610 is transferred to a receiver substrate, one or more of the other layers of the donor substrate may also be transferred. As the donor substrate may be inverted and then placed on the receiver substrate, the resulting stack may include a portion of the selective transfer layer 1610 on the receiver substrate and a protective layer above the selective transfer layer. In some embodiments, the protective layer may then be removed (e.g., via etching) or it may be preserved during subsequent processing.

In some embodiments, a tough layer may be formed within the release layer (e.g., above a metallic layer that is absorbed by the laser). The tough layer may comprise a material with a relatively high fracture toughness. In some embodiments, the tough layer may result in the total debonding stack having a fracture toughness that is higher than 0.9 megapascals times the square root of distance in meters (MPa m^1/2) (e.g., a fracture toughness higher than that of silica or silicon). The addition of the tough layer may increase the plastic zone and may arrest cracking due to pressure caused by the laser.

In various embodiments, the tough layer may predominately or substantially comprise a metal (e.g., tungsten (W), nickel (Ni), or titanium (Ti)) or a ceramic material (e.g., silicon nitride (SiN), silicon carbide (SiC), or aluminum oxide ($Al_2O_3$)). Other materials described above for release layers may also be used as a tough layer to protect against cracking.

FIG. 17 illustrates a protective debonding stack comprising a transformation layer 1712 formed on a donor substrate 1700. The stack comprises a release layer 1706 formed on a donor substrate (e.g., over a base substrate), transformation layer 1712 formed over the release layer 1706, and a selective transfer layer 1710 formed over the transformation layer 1710.

The transformation layer 1712 may undergo a phase transformation responsive to application of a stress (e.g., a local stress resulting from ablation pressure or a crack spreading due to application of a laser). The phase transformation results in a local volumetric change (increasing the volume of the material within the transformation layer 1712) that prevents cracking or arrests cracks propagating from the release layer 1706 towards the selective transfer layer 1710.

In various embodiments the transformation layer 1712 may comprise yttrium-doped zinc oxide (YZO), hafnium-doped zinc oxide (HZO), or other suitable phase change material. In some embodiments, the transformation layer can replace a dielectric layer within the release layer (e.g., above a metallic layer that is absorbed by the laser).

FIG. 18 illustrates a protective debonding stack comprising a compressive stress layer 1812 formed on a donor substrate 1800. The stack comprises a release layer 1806 formed on a donor substrate (e.g., over a base substrate), a compressive stress layer 1812 formed over a release layer 1806, and a selective transfer layer 1810 formed over the compressive stress layer 1812.

The compressive stress layer 1812 may have a relatively high compressive stress. For example, in some embodiments, the compressive stress may be greater than the compressive stress of the selective transfer layer 1810 and/or the release layer 1806. In one example, the compressive stress of the material in the compressive stress layer 1812 may be greater than 500 megapascals. The compressive stress layer 1812 may comprise one or more films that will create local compression around a crack tip, effectively pushing back on the crack and preventing the crack from opening further. In a particular embodiment, the compressive stress layer 1812 comprises silicon nitride.

**FIG. 19** illustrates a protective debonding stack comprising a patterned layer 1912 formed on a donor substrate 1900. The stack comprises a release layer 1906 formed on a donor substrate (e.g., over a base substrate), a patterned layer formed over the release layer 1906, and a selective transfer layer 1910 formed over the patterned layer 1912.

The patterned layer 1912 may include a first material and a second material that is dissimilar from the second material. In various embodiments, the first material may be formed in a pattern (e.g., of strips, pads, pillars, or other suitable shapes) within the patterned layer 1912 and the second material may fill the remaining volume of the patterned layer 1912 (or other portions of the patterned layer). Thus, the first material may form a plurality of inclusions and these inclusions may be disconnected from each other (in other embodiments, one or more inclusions may be connected to one or more other inclusions). A patterned film with inclusions increases the overall stack fracture toughness and introduces a crack deflection mechanism in the stack.

In various embodiments, the first material or second material may comprise an oxide, a nitride, a metal, or a metal alloy. In some examples, the first material comprises an oxide and the second material comprises a metal, or vice versa. In other examples, the first material comprises an oxide and the second material comprises a nitride, or vice versa. In yet other examples, the first material comprises a nitride and the second material comprises a metal, or vice versa. In various embodiments, the patterned layer 1912 may comprise one or more shapes (e.g., which may be the first material or the second material) comprising a metal, but the metallic shapes are not connected to any circuitry (e.g., of selective transfer layer 1910) and do not carry an electrical current.

**FIG. 20A-E** illustrate example patterned layers. FIG. 20A illustrates a cross section view of an example patterned layer which may correspond to a cross section taken through the dotted line of either of the plan views of example patterned layers depicted in FIG. 20B or 20C. FIG. 20D illustrates a cross section view of an example patterned layer corresponding to a cross section taken through the dotted line of the plan view of the example patterned layer depicted in FIG. 20E.

FIG. 20A depicts a first material 2002 patterned as vertical lines in the cross section and a second material 2004 that occupies the space not occupied by the first material. In some embodiments, the shapes formed by the first material may have a common pitch across the width and/or length of the patterned layer. In other embodiments, the distances between various pairs of adjacent shapes may vary.

FIG. 20B depicts a plan view corresponding to the patterned layer of FIG. 20A. The vertical lines formed by material 2002 shown in FIG. 20A also run as horizontal lines across the patterned layer as shown in FIG. 20B with the second material 2004 formed in between the lines.

FIG. 20C depicts another plan view of an example patterned layer. In this embodiment an additional set of horizontal lines that are orthogonal to the other horizontal lines are included, to further improve the protection provided by the patterned layer.

The introduction of a patterned layer containing lines (such as those shown in FIGS. 20A-20C or other lines) may result in crack bridging as a toughening mechanism for the stack. If a crack is trying to propagate towards the selective transfer layer, the lines may serve as a bridge connecting two edges of the crack.

FIG. 20D depicts the first material 2002 patterned as vertical pillars. FIG. 20E shows a plan view of the vertical pillars. In this embodiment, the vertical pillars have a square shaped horizontal cross section, though other embodiments may have any suitably shaped cross section. Respective pillars are surrounded by the second material 2004.

**FIG. 21** illustrates a protective debonding stack comprising a reflector stack 2112 formed on a donor substrate 2100. Each illustrative stack comprises a release layer 2106 formed on a donor substrate (e.g., over a base substrate), a reflector stack 2112 formed over the release layer 2106, and a selective transfer layer 2110 formed over the reflector stack 2112.

The reflector stack 2112 may comprise a Bragg reflector-type structure with alternating layers of acoustic impedance-mismatched materials that can reflect the ablation-induced shock wave and decrease the dynamic strain transferred to the selective transfer layer 2110. Reflector stack 2112 may comprise different materials that repeat periodically within the stack. For example, in the embodiment depicted, a layer of a first material 2114 is stacked on a layer of a second material 2116 which in turn is stacked on another layer of the first material 2114 which is stacked on another layer of the second material 2116 and so on. In some embodiments, the first material/second material pairs may comprise $W/SiO_2$, $Mo/SiO_2$, Mo/AlN, W/AlN, W/Al, Mo/Al, or Mo/Ti, although other suitable pairs are contemplated by the present disclosure.

The combination is one high acoustic impedance and one low acoustic impedance pair. While any dissimilar material combination works, the larger the delta, it becomes more efficient. Thickness range of each material may be written between 100nm and 5um.

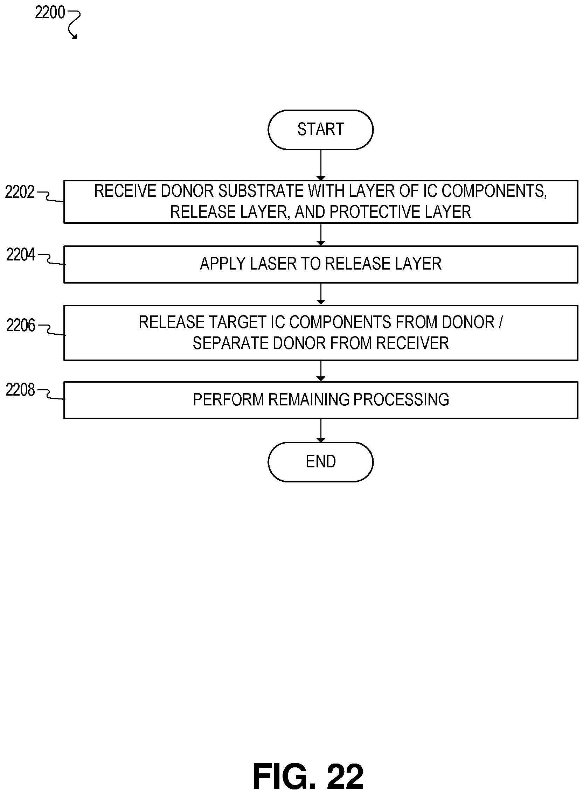

**FIG. 22** illustrates a flowchart 2200 for performing selective layer transfers using a protective debonding stack. It will be appreciated in light of the present disclosure that the illustrated process flow is only one example methodology for performing selective layer transfers. Moreover, the steps of the illustrated process flow may be performed using any suitable semiconductor fabrication techniques such as those described herein or other suitable techniques.

The flowchart begins at block 2202 by receiving a first substrate (e.g., a donor substrate) with a layer of integrated circuit (IC) components (e.g., a selective transfer layer), a release layer, and a protective layer. In some embodiments, one or more additional layers may be on the donor substrate.

In some embodiments, the donor substrate with the layer of IC components may be formed by receiving the donor substrate, forming the release layer over the donor substrate, forming the protective layer over the release layer, and forming the layer of IC components over the release layer (e.g., by fabricating or transferring the layer of IC components over the release layer), and/or partially singulating the layer of IC components (e.g., by dicing through the layer of IC components without dicing completely through the donor substrate).

In various embodiments, the layer of IC components may include one or more IC dies, interconnects, transistors, diodes, resistors, capacitors, inductors, transformers, optical components, and/or any other active or passive circuitry or other components (e.g., as described herein).

The donor substrate and its various layers (e.g., release layer, protective layer, selective transfer layer) may be made of various materials such as those described above (e.g., in connection with FIGS 1-7 or FIGS. 16-21 or elsewhere herein) or other suitable materials.

The flowchart then proceeds to block 2204, where a laser is applied to the release layer. For example, laser exposure may be applied using any of the techniques described herein (e.g., in connection with FIGs. 9A-9C) or other suitable techniques. The laser may be applied either before the donor substrate is placed in contact with a receiver substrate or after the donor substrate is at least partially bonded with the receiver substrate (e.g., while the donor substrate is in contact with the receiver substrate before the selective transfer is completed).

The flowchart then proceeds to block 2206 where the target IC components are released from the donor substrate and the donor substrate and receiver substrate (which may have any suitable characteristics of other receiver substrates described herein) are separated. When the donor and receiver substrates are separated, the target IC components are separated from the donor substrate and remain on the receiver substrate.

The flowchart then proceeds to block 2208 to perform any remaining processing, such as removing (e.g., etching away) the protective layer or other underlying layers transferred from the donor substrate (though in some embodiments, the protective layer may be left intact in the final product), dielectric filling and planarization, attaching additional IC dies or components (e.g., via selective transfers or pick-and-place assembly), forming interconnects (e.g., vias, traces), attaching a structural substrate, debonding the receiver substrate (e.g., via the optional receiver release layer), and/or any other processing required for the finished product (e.g., an IC package, device, system, etc.).

The completed product may include a variety of components and circuitry (some of which may have been selectively transferred), including any of the components and circuitry described above in connection with FIG. 7 or other suitable components or circuitry.

Further, in some embodiments, the resulting IC package or product may be electrically coupled to a circuit board and/or incorporated into an electronic device or system (e.g., with other electronic components).

At this point, the flowchart may be complete. In some embodiments, however, the flowchart may restart and/or certain blocks may be repeated. For example, in some embodiments, the flowchart may restart at block 2202 to continue performing selective transfers or move to block 2206 for a different receiver substrate.

*Example Embodiments*

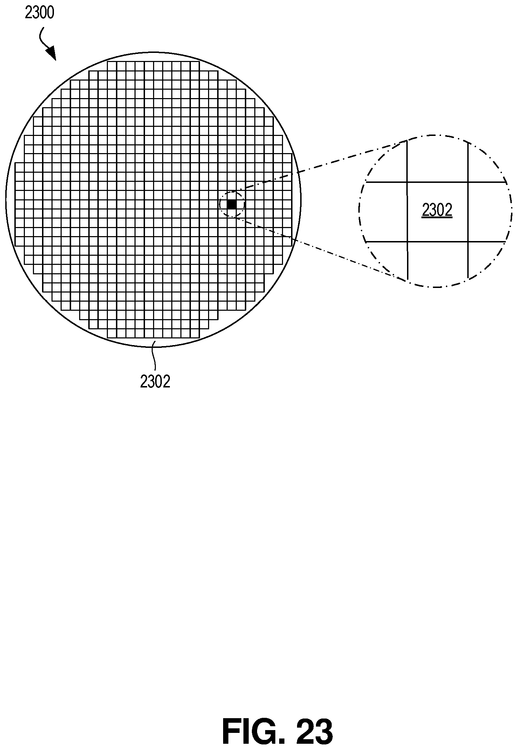

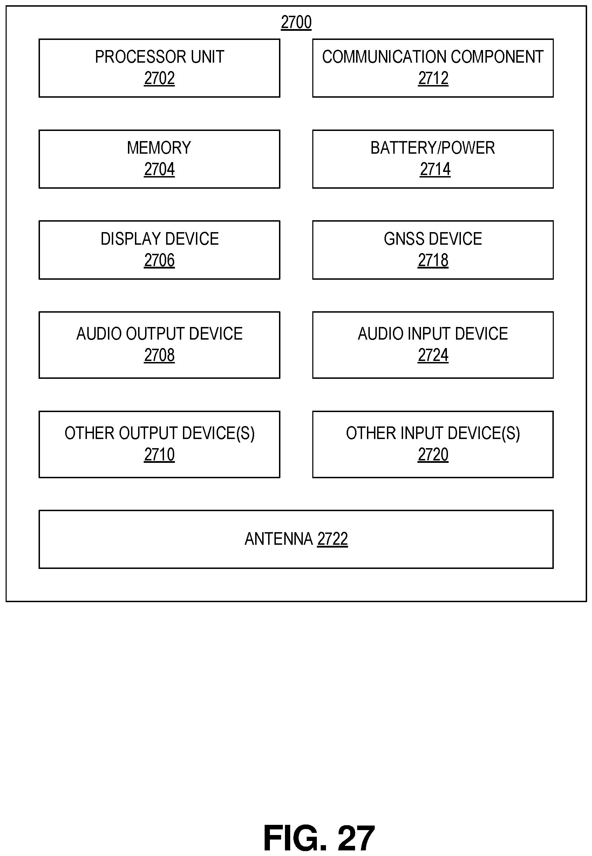

FIG. 23 is a top view of a wafer 2300 and dies 2302, wherein individual dies may include dies selectively transferred from donor wafers or dies integrated together in a system with such dies as disclosed herein. The wafer 2300 may be composed of semiconductor material and may include one or more dies 2302 having integrated circuit structures formed on a surface of the wafer 2300. The individual dies 2302 may be a repeating unit of an integrated circuit product that includes any suitable integrated circuit. After the fabrication of the semiconductor product is complete, the wafer 2300 may undergo a singulation process in which the dies 2302 are separated from one another to provide discrete "chips" of the integrated circuit product. The die 2302 may include one or more transistors, supporting circuitry to route electrical signals to the transistors, passive components (e.g., signal traces, resistors, capacitors, or inductors), and/or any other integrated circuit components. In some embodiments, the wafer 2300 or the die 2302 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 2302. For example, a memory array formed by multiple memory devices may be formed on a same die 2302 as a processor unit (e.g., the processor unit 2702 of FIG. 27) or other logic that is configured to store information in the memory devices or execute instructions stored in the memory array. In some embodiments, various ones of the microelectronic assemblies disclosed herein may be manufactured using a die-to-wafer assembly technique in which some dies are attached to a wafer 2300 that include other dies, and the wafer 2300 is subsequently singulated.

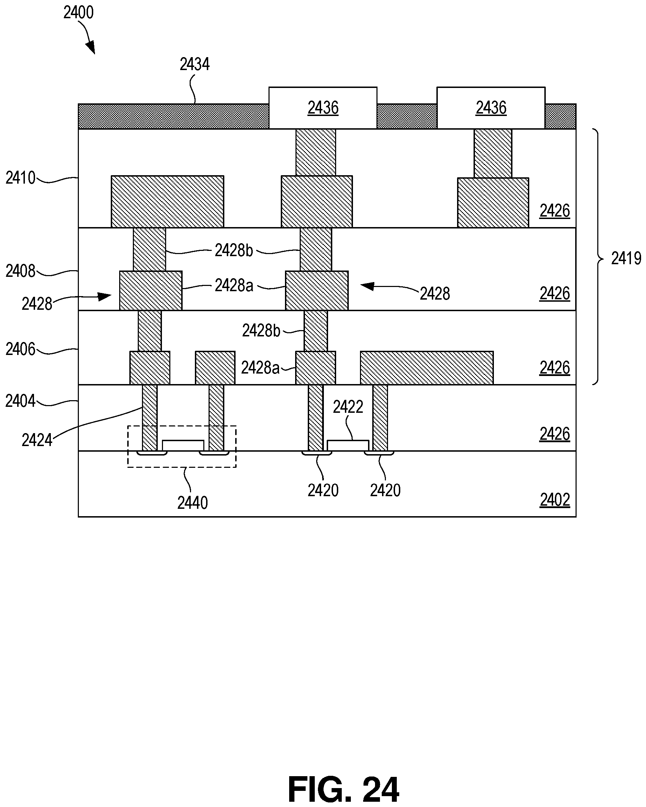

FIG. 24 is a cross-sectional side view of an integrated circuit device 2400 that may be included within IC components, such as dies, selectively transferred from donor wafers or circuitry incorporating such IC components as disclosed herein. One or more of the integrated circuit devices 2400 may be included in one or more dies 2302 (FIG. 23). The integrated circuit device 2400 may be formed on a die substrate 2402 (e.g., the wafer 2300 of FIG. 23) and may be included in a die (e.g., the die 2302 of FIG. 23). The die substrate 2402 may be a semiconductor substrate composed of semiconductor material systems including, for example, n-type or p-type materials systems (or a combination of both). The die substrate 2402 may include, for example, a crystalline substrate formed using a bulk silicon or a silicon-on-insulator (SOI) substructure. In some embodiments, the die substrate 2402 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 2402. Although a few examples of materials from which the die substrate 2402 may be formed are described here, any material that may serve as a foundation for an integrated circuit device 2400 may be used. The die substrate 2402 may be part of a singulated die (e.g., the dies 2302 of FIG. 23) or a wafer (e.g., the wafer 2300 of FIG. 23).

The integrated circuit device 2400 may include one or more device layers 2404 disposed on the die substrate 2402. The device layer 2404 may include features of one or more transistors 2440 (e.g., metal oxide semiconductor field-effect transistors (MOSFETs)) formed on the die substrate 2402. The transistors 2440 may include, for example, one or more source and/or drain (S/D) regions 2420, a gate 2422 to control current flow between the S/D regions 2420, and one or more S/D contacts 2424 to route electrical signals to/from the S/D regions 2420. The transistors 2440 may include additional features not depicted for the sake of clarity, such as device isolation regions, gate contacts, and the like. The transistors 2440 are not limited to the type and configuration depicted in FIG. 24 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

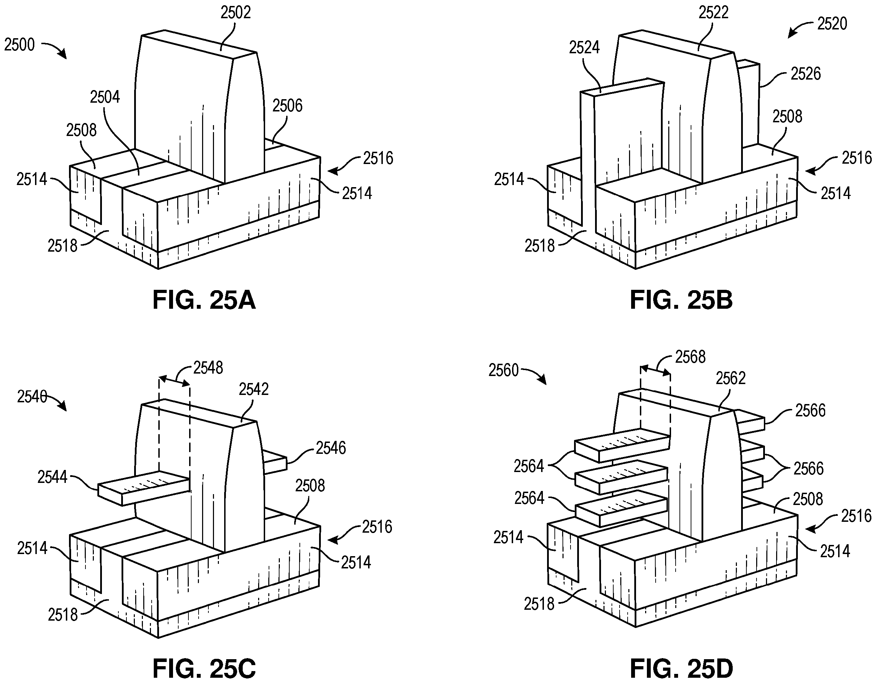

FIGS. 25A-25D are simplified perspective views of example planar, FinFET, gate-all-around, and stacked gate-all-around transistors. The transistors illustrated in FIGS. 25A-25D are formed on a substrate 2516 having a surface 2508. Isolation regions 2514 separate the source and drain regions of the transistors from other transistors and from a bulk region 2518 of the substrate 2516.

FIG. 25A is a perspective view of an example planar transistor 2500 comprising a gate 2502 that controls current flow between a source region 2504 and a drain region 2506. The transistor 2500 is planar in that the source region 2504 and the drain region 2506 are planar with respect to the substrate surface 2508.

FIG. 25B is a perspective view of an example FinFET transistor 2520 comprising a gate 2522 that controls current flow between a source region 2524 and a drain region 2526. The transistor 2520 is non-planar in that the source region 2524 and the drain region 2526 comprise "fins" that extend upwards from the substrate surface 2528. As the gate 2522 encompasses three sides of the semiconductor fin that extends from the source region 2524 to the drain region 2526, the transistor 2520 can be considered a tri-gate transistor. FIG. 25B illustrates one S/D fin extending through the gate 2522, but multiple S/D fins can extend through the gate of a FinFET transistor.

FIG. 25C is a perspective view of a gate-all-around (GAA) transistor 2540 comprising a gate 2542 that controls current flow between a source region 2544 and a drain region 2546. The transistor 2540 is non-planar in that the source region 2544 and the drain region 2546 are elevated from the substrate surface 2528.

FIG. 25D is a perspective view of a GAA transistor 2560 comprising a gate 2562 that controls current flow between multiple elevated source regions 2564 and multiple elevated drain regions 2566. The transistor 2560 is a stacked GAA transistor as the gate controls the flow of current between multiple elevated S/D regions stacked on top of each other. The transistors 2540 and 2560 are considered gate-all-around transistors as the gates encompass all sides of the semiconductor portions that extends from the source regions to the drain regions. The transistors 2540 and 2560 can alternatively be referred to as nanowire, nanosheet, or nanoribbon transistors depending on the width (e.g., widths 2548 and 2568 of transistors 2540 and 2560, respectively) of the semiconductor portions extending through the gate.

Returning to FIG. 24, a transistor 2440 may include a gate 2422 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 2440 is to be a p-type metal oxide semiconductor (PMOS) or an n-type metal oxide semiconductor (NMOS) transistor. In some implementations, the gate electrode may consist of or comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 2440 along the source-channel-drain direction, the gate electrode may consist of or comprise a U-shaped structure that includes a bottom portion substantially parallel to the surface of the die substrate 2402 and two sidewall portions that are substantially perpendicular to the top surface of the die substrate 2402. In other embodiments, at least one of the metal layers that form the gate electrode may simply be a planar layer that is substantially parallel to the top surface of the die substrate 2402 and does not include sidewall portions substantially perpendicular to the top surface of the die substrate 2402. In other embodiments, the gate electrode may consist of or comprise a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2420 may be formed within the die substrate 2402 adjacent to the gate 2422 of individual transistors 2440. The S/D regions 2420 may be formed using an implantation/diffusion process or an etching/deposition process, for example. In the former process, dopants such as boron, aluminum, antimony, phosphorous, or arsenic may be ion-implanted into the die substrate 2402 to form the S/D regions 2420. An annealing process that activates the dopants and causes them to diffuse farther into the die substrate 2402 may follow the ion-implantation process. In the latter process, the die substrate 2402 may first be etched to form recesses at the locations of the S/D regions 2420. An epitaxial deposition process may then be carried out to fill the recesses with material that is used to fabricate the S/D regions 2420. In some implementations, the S/D regions 2420 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2420 may be formed using one or more alternate semiconductor materials such as germanium or a group III-V material or alloy. In further embodiments, one or more layers of metal and/or metal alloys may be used to form the S/D regions 2420.

Electrical signals, such as power and/or input/output (I/O) signals, may be routed to and/or from the devices (e.g., transistors 2440) of the device layer 2404 through one or more interconnect layers disposed on the device layer 2404 (illustrated in FIG. 24 as interconnect layers 2406-2410). For example, electrically conductive features of the device layer 2404 (e.g., the gate 2422 and the S/D contacts 2424) may be electrically coupled with the interconnect structures 2428 of the interconnect layers 2406-2410. The one or more interconnect layers 2406-2410 may form a metallization stack (also referred to as an "ILD stack") 2419 of the integrated circuit device 2400.

The interconnect structures 2428 (e.g., lines) may be arranged within the interconnect layers 2406-2410 to route electrical signals according to a wide variety of designs; in particular, the arrangement is not limited to the particular configuration of interconnect structures 2428 depicted in FIG. 24. Although a particular number of interconnect layers 2406-2410 is depicted in FIG. 24, embodiments of the present disclosure include integrated circuit devices having more or fewer interconnect layers than depicted.

In some embodiments, the interconnect structures 2428 may include lines 2428a and/or vias 2428b filled with an electrically conductive material such as a metal. The lines 2428a may be arranged to route electrical signals in a direction of a plane that is substantially parallel with a surface of the die substrate 2402 upon which the device layer 2404 is formed. For example, the lines 2428a may route electrical signals in a direction in and out of the page and/or in a direction across the page. The vias 2428b may be arranged to route electrical signals in a direction of a plane that is substantially perpendicular to the surface of the die substrate 2402 upon which the device layer 2404 is formed. In some embodiments, the vias 2428b may electrically couple lines 2428a of different interconnect layers 2406-2410 together.

The interconnect layers 2406-2410 may include a dielectric material 2426 disposed between the interconnect structures 2428, as shown in FIG. 24. In some embodiments, dielectric material 2426 disposed between the interconnect structures 2428 in different ones of the interconnect layers 2406-2410 may have different compositions; in other embodiments, the composition of the dielectric material 2426 between different interconnect layers 2406-2410 may be the same. The device layer 2404 may include a dielectric material 2426 disposed between the transistors 2440 and a bottom layer of the metallization stack as well. The dielectric material 2426 included in the device layer 2404 may have a different composition than the dielectric material 2426 included in the interconnect layers 2406-2410; in other embodiments, the composition of the dielectric material 2426 in the device layer 2404 may be the same as a dielectric material 2426 included in any one of the interconnect layers 2406-2410.

A first interconnect layer 2406 (referred to as Metal 1 or "M1") may be formed directly on the device layer 2404. In some embodiments, the first interconnect layer 2406 may include lines 2428a and/or vias 2428b, as shown. The lines 2428a of the first interconnect layer 2406 may be coupled with contacts (e.g., the S/D contacts 2424) of the device layer 2404. The vias 2428b of the first interconnect layer 2406 may be coupled with the lines 2428a of a second interconnect layer 2408.

The second interconnect layer 2408 (referred to as Metal 2 or "M2") may be formed directly on the first interconnect layer 2406. In some embodiments, the second interconnect layer 2408 may include via 2428b to couple the lines 2428 of the second interconnect layer 2408 with the lines 2428a of a third interconnect layer 2410. Although the lines 2428a and the vias 2428b are structurally delineated with a line within individual interconnect layers for the sake of clarity, the lines 2428a and the vias 2428b may be structurally and/or materially contiguous (e.g., simultaneously filled during a dual-damascene process) in some embodiments.

The third interconnect layer 2410 (referred to as Metal 3 or "M3") (and additional interconnect layers, as desired) may be formed in succession on the second interconnect layer 2408 according to similar techniques and configurations described in connection with the second interconnect layer 2408 or the first interconnect layer 2406. In some embodiments, the interconnect layers that are "higher up" in the metallization stack 2419 in the integrated circuit device 2400 (i.e., farther away from the device layer 2404) may be thicker that the interconnect layers that are lower in the metallization stack 2419, with lines 2428a and vias 2428b in the higher interconnect layers being thicker than those in the lower interconnect layers.

The integrated circuit device 2400 may include a solder resist material 2434 (e.g., polyimide or similar material) and one or more conductive contacts 2436 formed on the interconnect layers 2406-2410. In FIG. 24, the conductive contacts 2436 are illustrated as taking the form of bond pads. The conductive contacts 2436 may be electrically coupled with the interconnect structures 2428 and configured to route the electrical signals of the transistor(s) 2440 to external devices. For example, solder bonds may be formed on the one or more conductive contacts 2436 to mechanically and/or electrically couple an integrated circuit die including the integrated circuit device 2400 with another component (e.g., a printed circuit board). The integrated circuit device 2400 may include additional or alternate structures to route the electrical signals from the interconnect layers 2406-2410; for example, the conductive contacts 2436 may include other analogous features (e.g., posts) that route the electrical signals to external components.

In some embodiments in which the integrated circuit device 2400 is a double-sided die, the integrated circuit device 2400 may include another metallization stack (not shown) on the opposite side of the device layer(s) 2404. This metallization stack may include multiple interconnect layers as discussed above with reference to the interconnect layers 2406-2410, to provide conductive pathways (e.g., including conductive lines and vias) between the device layer(s) 2404 and additional conductive contacts (not shown) on the opposite side of the integrated circuit device 2400 from the conductive contacts 2436.

In other embodiments in which the integrated circuit device 2400 is a double-sided die, the integrated circuit device 2400 may include one or more through silicon vias (TSVs) through the die substrate 2402; these TSVs may make contact with the device layer(s) 2404, and may provide conductive pathways between the device layer(s) 2404 and additional conductive contacts (not shown) on the opposite side of the integrated circuit device 2400 from the conductive contacts 2436. In some embodiments, TSVs extending through the substrate can be used for routing power and ground signals from conductive contacts on the opposite side of the integrated circuit device 2400 from the conductive contacts 2436 to the transistors 2440 and any other components integrated into the integrated circuit device (e.g., die) 2400, and the metallization stack 2419 can be used to route I/O signals from the conductive contacts 2436 to transistors 2440 and any other components integrated into the integrated circuit device (e.g., die) 2400.

Multiple integrated circuit devices 2400 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adj acent integrated circuit dies in the stack. In some embodiments, the conductive contacts can be fine-pitch solder bumps (microbumps).

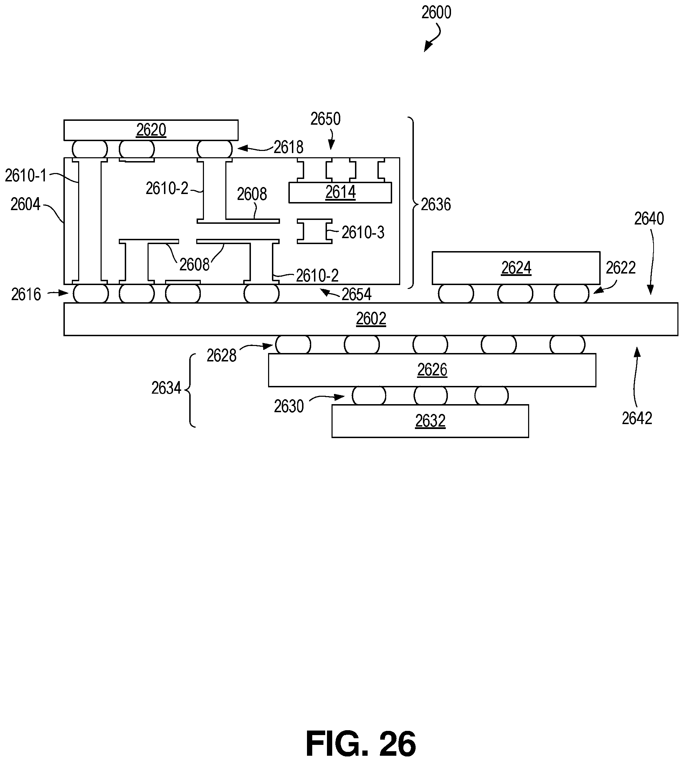

FIG. 26 is a cross-sectional side view of an integrated circuit device assembly 2600 that may include IC components, such as dies, selectively transferred from donor wafers as disclosed herein. In some embodiments, the integrated circuit device assembly 2600 may be a microelectronic assembly. The integrated circuit device assembly 2600 includes a number of components disposed on a circuit board 2602 (which may be a motherboard, system board, mainboard, etc.). The integrated circuit device assembly 2600 includes components disposed on a first face 2640 of the circuit board 2602 and an opposing second face 2642 of the circuit board 2602; generally, components may be disposed on one or both faces 2640 and 2642.

In some embodiments, the circuit board 2602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 2602. In other embodiments, the circuit board 2602 may be a non-PCB substrate. The integrated circuit device assembly 2600 illustrated in FIG. 26 includes a package-on-interposer structure 2636 coupled to the first face 2640 of the circuit board 2602 by coupling components 2616. The coupling components 2616 may electrically and mechanically couple the package-on-interposer structure 2636 to the circuit board 2602, and may include solder balls (as shown in FIG. 26), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 2636 may include an integrated circuit component 2620 coupled to an interposer 2604 by coupling components 2618. The coupling components 2618 may take any suitable form for the application, such as the forms discussed above with reference to the coupling components 2616.

Although a single integrated circuit component 2620 is shown in FIG. 26, multiple integrated circuit components may be coupled to the interposer 2604; indeed, additional interposers may be coupled to the interposer 2604. The interposer 2604 may provide an intervening substrate used to bridge the circuit board 2602 and the integrated circuit component 2620.

The integrated circuit component 2620 may be a packaged or unpackaged integrated circuit product that includes one or more integrated circuit dies (e.g., the die 2302 of FIG. 23, the integrated circuit device 2400 of FIG. 24) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 2620, a single monolithic integrated circuit die comprises solder bumps attached to contacts on the die. The solder bumps allow the die to be directly attached to the interposer 2604. The integrated circuit component 2620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 2620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 2620 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 2620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel® embedded multi-die interconnect bridges (EMIBs)), or combinations thereof.

Generally, the interposer 2604 may spread connections to a wider pitch or reroute a connection to a different connection. For example, the interposer 2604 may couple the integrated circuit component 2620 to a set of ball grid array (BGA) conductive contacts of the coupling components 2616 for coupling to the circuit board 2602. In the embodiment illustrated in FIG. 26, the integrated circuit component 2620 and the circuit board 2602 are attached to opposing sides of the interposer 2604; in other embodiments, the integrated circuit component 2620 and the circuit board 2602 may be attached to a same side of the interposer 2604. In some embodiments, three or more components may be interconnected by way of the interposer 2604.

In some embodiments, the interposer 2604 may be formed as a PCB, including multiple metal layers separated from one another by layers of dielectric material and interconnected by electrically conductive vias. In some embodiments, the interposer 2604 may be formed of an epoxy resin, a fiberglass-reinforced epoxy resin, an epoxy resin with inorganic fillers, a ceramic material, or a polymer material such as polyimide. In some embodiments, the interposer 2604 may be formed of alternate rigid or flexible materials that may include the same materials described above for use in a semiconductor substrate, such as silicon, germanium, and other group III-V and group IV materials. The interposer 2604 may include metal interconnects 2608 and vias 2610, including but not limited to through hole vias 2610-1 (that extend from a first face 2650 of the interposer 2604 to a second face 2654 of the interposer 2604), blind vias 2610-2 (that extend from the first or second faces 2650 or 2654 of the interposer 2604 to an internal metal layer), and buried vias 2610-3 (that connect internal metal layers).

In some embodiments, the interposer 2604 can comprise a silicon interposer. Through silicon vias (TSV) extending through the silicon interposer can connect connections on a first face of a silicon interposer to an opposing second face of the silicon interposer. In some embodiments, an interposer 2604 comprising a silicon interposer can further comprise one or more routing layers to route connections on a first face of the interposer 2604 to an opposing second face of the interposer 2604.

The interposer 2604 may further include embedded devices 2614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 2604. The package-on-interposer structure 2636 may take the form of any of the package-on-interposer structures known in the art.

The integrated circuit device assembly 2600 may include an integrated circuit component 2624 coupled to the first face 2640 of the circuit board 2602 by coupling components 2622. The coupling components 2622 may take the form of any of the embodiments discussed above with reference to the coupling components 2616, and the integrated circuit component 2624 may take the form of any of the embodiments discussed above with reference to the integrated circuit component 2620.

The integrated circuit device assembly 2600 illustrated in FIG. 26 includes a package-on-package structure 2634 coupled to the second face 2642 of the circuit board 2602 by coupling components 2628. The package-on-package structure 2634 may include an integrated circuit component 2626 and an integrated circuit component 2632 coupled together by coupling components 2630 such that the integrated circuit component 2626 is disposed between the circuit board 2602 and the integrated circuit component 2632. The coupling components 2628 and 2630 may take the form of any of the embodiments of the coupling components 2616 discussed above, and the integrated circuit components 2626 and 2632 may take the form of any of the embodiments of the integrated circuit component 2620 discussed above. The package-on-package structure 2634 may be configured in accordance with any of the package-on-package structures known in the art.

FIG. 27 is a block diagram of an example electrical device 2700 that may include IC components, such as dies, selectively transferred from donor wafers as disclosed herein. For example, any suitable components of the electrical device 2700 may include one or more of the integrated circuit device assemblies 2600, integrated circuit components 2620, integrated circuit devices 2400, integrated circuit dies 2302, or other components disclosed herein. A number of components are illustrated in FIG. 27 as included in the electrical device 2700, but any one or more of these components may be omitted or duplicated, as suitable for the application. In some embodiments, some or all of the components included in the electrical device 2700 may be attached to one or more motherboards mainboards, or system boards. In some embodiments, one or more of these components are fabricated onto a single system-on-a-chip (SoC) die.

Additionally, in various embodiments, the electrical device 2700 may not include one or more of the components illustrated in FIG. 27, but the electrical device 2700 may include interface circuitry for coupling to the one or more components. For example, the electrical device 2700 may not include a display device 2706, but may include display device interface circuitry (e.g., a connector and driver circuitry) to which a display device 2706 may be coupled. In another set of examples, the electrical device 2700 may not include an audio input device 2724 or an audio output device 2708, but may include audio input or output device interface circuitry (e.g., connectors and supporting circuitry) to which an audio input device 2724 or audio output device 2708 may be coupled.

The electrical device 2700 may include one or more processor units 2702 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 2702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 2700 may include a memory 2704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 2704 may include memory that is located on the same integrated circuit die as the processor unit 2702. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 2700 can comprise one or more processor units 2702 that are heterogeneous or asymmetric to another processor unit 2702 in the electrical device 2700. There can be a variety of differences between the processing units 2702 in a system in terms of a spectrum of metrics of merit including architectural, microarchitectural, thermal, power consumption characteristics, and the like. These differences can effectively manifest themselves as asymmetry and heterogeneity among the processor units 2702 in the electrical device 2700.

In some embodiments, the electrical device 2700 may include a communication component 2712 (e.g., one or more communication components). For example, the communication component 2712 can manage wireless communications for the transfer of data to and from the electrical device 2700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 2712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 2712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 2712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 2712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 2712 may operate in accordance with other wireless protocols in other embodiments. The electrical device 2700 may include an antenna 2722 to facilitate wireless communications and/or to receive other wireless communications (such as amplitude modulation (AM) or frequency modulation (FM) radio transmissions).

In some embodiments, the communication component 2712 may manage wired communications, such as electrical, optical, or any other suitable communication protocols (e.g., IEEE 802.3 Ethernet standards). As noted above, the communication component 2712 may include multiple communication components. For instance, a first communication component 2712 may be dedicated to shorter-range wireless communications such as Wi-Fi or Bluetooth, and a second communication component 2712 may be dedicated to longer-range wireless communications such as global positioning system (GPS), EDGE, GPRS, CDMA, WiMAX, LTE, EV-DO, or others. In some embodiments, a first communication component 2712 may be dedicated to wireless communications, and a second communication component 2712 may be dedicated to wired communications.

The electrical device 2700 may include battery/-

power circuitry 2714. The battery/power circuitry 2714 may include one or more energy storage devices (e.g., batteries or capacitors) and/or circuitry for coupling components of the electrical device 2700 to an energy source separate from the electrical device 2700 (e.g., AC line power).

The electrical device 2700 may include a display device 2706 (or corresponding interface circuitry, as discussed above). The display device 2706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 2700 may include an audio output device 2708 (or corresponding interface circuitry, as discussed above). The audio output device 2708 may include any embedded or wired or wirelessly connected external device that generates an audible indicator, such speakers, headsets, or earbuds.

The electrical device 2700 may include an audio input device 2724 (or corresponding interface circuitry, as discussed above). The audio input device 2724 may include any embedded or wired or wirelessly connected device that generates a signal representative of a sound, such as microphones, microphone arrays, or digital instruments (e.g., instruments having a musical instrument digital interface (MIDI) output). The electrical device 2700 may include a Global Navigation Satellite System (GNSS) device 2718 (or corresponding interface circuitry, as discussed above), such as a Global Positioning System (GPS) device. The GNSS device 2718 may be in communication with a satellite-based system and may determine a geolocation of the electrical device 2700 based on information received from one or more GNSS satellites, as known in the art.

The electrical device 2700 may include an other output device 2710 (or corresponding interface circuitry, as discussed above). Examples of the other output device 2710 may include an audio codec, a video codec, a printer, a wired or wireless transmitter for providing information to other devices, or an additional storage device.

The electrical device 2700 may include an other input device 2720 (or corresponding interface circuitry, as discussed above). Examples of the other input device 2720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 2700 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 2700 may be any other electronic device that processes data. In some embodiments, the electrical device 2700 may comprise multiple discrete physical components. Given the range of devices that the electrical device 2700 can be manifested as in various embodiments, in some embodiments, the electrical device 2700 can be referred to as a computing device or a computing system.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

It will also be understood that, although the terms "first," "second," and so forth may be used herein to describe various elements, these elements should not be limited by these terms. These terms are only used to distinguish one element from another, and are not intended to imply that the objects so described must be in a given sequence, either temporally, spatially, in ranking or in any other manner. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. For example, the phrase "A and/or B" means (A), (B), or (A and B), while the phrase "A, B, and/or C" means (A), (B), (C), (A and B), (A and C), (B and C), or (A, B, and C).

As used throughout this description, and in the claims, a list of items joined by the term "at least one of" or "one or more of' can mean any combination of the listed terms.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Furthermore, the terms "comprising," "including," "having," and the like, as used with respect to embodiments of the present disclosure, are synonymous.

The description may use the phrases "in an embodiment," "according to some embodiments," "in accordance with embodiments," or "in embodiments," which may each refer to one or more of the same or different embodiments.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to $10^7$ Siemens per meter (S/m) at 20 degrees Celsius. Examples of such materials include Cu, Ag, Al, Au, W, Zn and Ni.

The term "signal" may refer to at least one current signal, voltage signal, magnetic signal, or data/-clock signal.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices.

The description may use perspective-based descriptions such as top/bottom, in/out, over/under, and the like. Such descriptions are merely used to facilitate the discussion and are not intended to restrict the application of embodiments described herein to any particular orientation.

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer means that at least a part of the first material or layer is in direct physical contact with at least a part of that second material/layer. Similar distinctions are to be made in the context of component assemblies.

As used herein, "A is adj acent to B" means that at least part of A is in direct physical contact with at least a part of B.

As used herein, "A is proximate to B" may mean that A is adjacent to B or A is otherwise near to B.

Unless otherwise specified in the specific context of use, the term "predominantly" means more than 50%, or more than half. For example, a composition that is predominantly a first constituent means more than half of the composition (e.g., by volume) is the first constituent (e.g., >50 at. %). The term "primarily" means the most, or greatest, part. For example, a composition that is primarily a first constituent means the composition has more of the first constituent (e.g., by volume) than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

The terms "substantially," "close," "approximately," "near," and "about," generally refer to being within +/- 10% of a target value (unless specifically specified).

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.

Although the figures may illustrate embodiments where structures are substantially aligned to Cartesian axes (e.g., device structures having substantially vertical sidewalls), positive and negative (re-entrant) sloped feature sidewalls often occur in practice. For example, manufacturing non-idealities may cause one or more structural features to have sloped sidewalls. Thus, attributes illustrated are idealized merely for the sake of clearly describing salient features. It is to be understood that schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes an electronic device, comprising an integrated circuit (IC) die having a thickness of 5 micrometers or less; and a mesa structure under the IC die, the mesa structure extending upward from a substrate, wherein the mesa structure has a footprint substantially similar to a footprint of the IC die.

Example 2 includes the subject matter of Example 1, and further including a residue material in contact with a side of the IC die.

Example 3 includes the subject matter of any of Examples 1 and 2, and wherein the residue material comprises oxygen, carbon, or hydrogen.

Example 4 includes the subject matter of any of Examples 1-3, and wherein the residue material comprises a photoresist material.

Example 5 includes the subject matter of any of Examples 1-4, and wherein the residue material comprises an adhesive material.

Example 6 includes the subject matter of any of Examples 1-5, and further including a dielectric material between the IC die and the mesa structure.

Example 7 includes the subject matter of any of Examples 1-6, and wherein the dielectric material comprises at least one of an oxide, a nitride, or a photoresist material.

Example 8 includes a method comprising receiving a substrate comprising a first layer, a second layer over the first layer, and a third layer over the second layer, the second layer comprising at least one integrated circuit (IC) component, the third layer comprising at least one dielectric material; and using a laser to weaken the first layer to facilitate separation of the second layer from the substrate.

Example 9 includes the subject matter of Example 8, and wherein the third layer comprises at least one of an oxide or a nitride.

Example 10 includes the subject matter of any of Examples 8 and 9, and wherein the third layer comprises a photoresist material.

Example 11 includes the subject matter of any of Examples 8-10, and wherein the third layer comprises an adhesive and glass.

Example 12 includes the subject matter of any of Examples 8-11, and further including removing the third layer.

Example 13 includes the subject matter of any of Examples 8-12, and wherein removing the third layer comprises applying an etch to the third layer.

Example 14 includes the subject matter of any of Examples 8-13, and wherein removing the third layer comprises applying a light source to the third layer.

Example 15 includes the subject matter of any of Examples 8-14, and further including transferring portions of the second layer from the substrate to a second substrate.

Example 16 includes the subject matter of any of Examples 8-15, and further including transferring second portions of the second layer from the substrate to a third substrate.

Example 17 includes an apparatus comprising a substrate; a first layer over the substrate; a second layer comprising integrated circuit (IC) components over the first layer; and a third layer over the second layer, the third layer comprising at least one dielectric material.

Example 18 includes the subject matter of Example 17, and wherein the third layer comprises at least one of an oxide or a nitride.

Example 19 includes the subject matter of any of Examples 17 and 18, and wherein the third layer comprises a photoresist material.

Example 20 includes the subject matter of any of Examples 17-19, and wherein the third layer comprises an adhesive and glass.

Example 21 includes an apparatus comprising a chuck comprising a first portion to interface with a wafer, the first portion being porous; and a second portion coupled to the first portion, the second portion comprising at least one vacuum port.

Example 22 includes the subj ect matter of Example 21, and wherein an average pore size of the first portion is less than 5 micrometers.

Example 23 includes the subject matter of any of Examples 21-22, and wherein the first portion comprises a ceramic material.

Example 24 includes the subject matter of any of Examples 21-23, and further including a laser to ablate portions of the wafer, wherein a diameter of a spot size of the laser is more than 10 times an average pore size of the first portion of the chuck.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

**Claims**

1. An electronic device, comprising:

   an integrated circuit (IC) die having a thickness of 5 micrometers ($\mu$m) or less; and
   a mesa structure under the IC die, the mesa structure extending upward from a substrate, wherein the mesa structure has a footprint substantially similar to a footprint of the IC die.

2. The electronic device of claim 1, further comprising a residue material in contact with a side of the IC die.

3. The electronic device of claim 2, wherein the residue material comprises oxygen, carbon, or hydrogen.

4. The electronic device of claim 2, wherein the residue material comprises a photoresist material.

5. The electronic device of claim 2, wherein the residue material comprises an adhesive material.

6. The electronic device of any of claims 1-5, further comprising a dielectric material between the IC die and the mesa structure.

7. The electronic device of claim 6, wherein the dielectric material comprises at least one of an oxide, a nitride, or a photoresist material.

8. A method, comprising:

   receiving a substrate comprising a first layer, a second layer over the first layer, and a third layer over the second layer, the second layer comprising at least one integrated circuit (IC) component, the third layer comprising at least one dielectric material; and
   using a laser to weaken the first layer to facilitate separation of the second layer from the substrate.

9. The method of claim 8, wherein the third layer comprises at least one of an oxide or a nitride.

10. The method of claim 8, wherein the third layer comprises a photoresist material.

11. The method of claim 8, wherein the third layer comprises an adhesive and glass.

12. The method of any of claims 8-11, further comprising removing the third layer after using the laser to weaken the first layer.

13. The method of claim 12, wherein removing the third layer comprises applying an etch to the third layer.

14. The method of claim 12, wherein removing the third layer comprises applying a light source to the third layer.

FIG. 1A
FIG. 1B
FIG. 1C
FIG. 1D
FIG. 1E
FIG. 1F
FIG. 1G
FIG. 1H
FIG. 1I

FIG. 2A

FIG. 2B

FIG. 2C

FIG. 2D

FIG. 2E

FIG. 2F

FIG. 2G

FIG. 2H

FIG. 2I

FIG. 3A
FIG. 3B
FIG. 3C
FIG. 3D
FIG. 3E
FIG. 3F
FIG. 3G
FIG. 3H
FIG. 3I

FIG. 4A

FIG. 4B

FIG. 4C

FIG. 5A
FIG. 5B
FIG. 5C
FIG. 5D
FIG. 5E
FIG. 5F

602

DONOR WAFER 600

612

RECEIVER WAFER 610

**FIG. 6A**

Selective Layer Transfer →

603
602

DONOR WAFER 600

602

RECEIVER WAFER 610

**FIG. 6B**

EP 4 542 631 A2

700

START

702 — RECEIVE DONOR SUBSTRATE WITH LAYER OF IC COMPONENTS

704 — RECEIVE RECEIVER SUBSTRATE PATTERNED WITH ADHESIVE AREAS

706 — PARTIALLY BOND DONOR TO RECEIVER
(WITH TARGET IC COMPONENTS ON DONOR SELECTIVELY BONDED TO ADHESIVE AREAS ON RECEIVER)

708 — RELEASE TARGET IC COMPONENTS FROM DONOR /
SEPARATE DONOR FROM RECEIVER

710 — PERFORM REMAINING PROCESSING

END

# FIG. 7

800
802

DONOR

804a   804b   804a   804b

**FIG. 8A**

820

800
802

DONOR

804a   804b   804a   804b

**FIG. 8B**

804a   804b   804a   804b

800
802

DONOR

810a

RECEIVER

812   812

**FIG. 8C**

800
802

DONOR

804a   804b   804a   804b

810a

RECEIVER

812   812

**FIG. 8D**

804b   804b

800
802

DONOR

810b

RECEIVER

812   812

**FIG. 8E**

FIG. 9A

FIG. 9B

EP 4 542 631 A2

FIG. 9C

EP 4 542 631 A2

1008

1014

1002

1016

1006

1004

1012

1010

**FIG. 10A**

1018

**FIG. 10B**

1108

1106

1104

1102

# FIG. 11

1208 1206 1204 1202

**FIG. 12A**

1210 1214 1202 1204 1216 1206 1208 1212

**FIG. 12B**

1206 1204 1200 1200

**FIG. 12C**

1200 1200 1204 1206 1222 1220

**FIG. 12D**

1310

1308

1306

1304

1302

**FIG. 13A**

1302

1312

1304

1306

1308

1310

**FIG. 13B**

1306

1304

1312

1302

**FIG. 13C**

1302

1312

1304

1306

1316

1314

**FIG. 13D**

**FIG. 14**

1500

```
                    ┌─────────────┐
                    │    START    │
                    └─────────────┘
                           │
                           ▼
1502  ┌────────────────────────────────────────────────────────┐
      │  RECEIVE DONOR SUBSTRATE WITH LAYER OF IC COMPONENTS,   │
      │   RELEASE LAYER, AND STRUCTURAL SUPPORT LAYER           │
      └────────────────────────────────────────────────────────┘
                           │
                           ▼
1504  ┌────────────────────────────────────────────────────────┐
      │           WEAKEN RELEASE LAYER USING LASER              │
      └────────────────────────────────────────────────────────┘
                           │
                           ▼
1506  ┌────────────────────────────────────────────────────────┐
      │            REMOVE STRUCTURAL SUPPORT LAYER              │
      └────────────────────────────────────────────────────────┘
                           │
                           ▼
1508  ┌────────────────────────────────────────────────────────┐
      │     RECEIVE RECEIVER SUBSTRATE WITH LAYER OF BONDING    │
      │                     STRUCTURES                          │
      └────────────────────────────────────────────────────────┘
                           │
                           ▼
1510  ┌────────────────────────────────────────────────────────┐
      │          PARTIALLY BOND DONOR TO RECEIVER              │
      │ (WITH TARGET IC COMPONENTS ON DONOR SELECTIVELY BONDED TO│
      │          BONDING STRUCTURES ON RECEIVER)                │
      └────────────────────────────────────────────────────────┘
                           │
                           ▼
1512  ┌────────────────────────────────────────────────────────┐
      │     RELEASE TARGET IC COMPONENTS FROM DONOR /          │
      │          SEPARATE DONOR FROM RECEIVER                  │
      └────────────────────────────────────────────────────────┘
                           │
                           ▼
1514  ┌────────────────────────────────────────────────────────┐
      │            PERFORM REMAINING PROCESSING                │
      └────────────────────────────────────────────────────────┘
                           │
                           ▼
                    ┌─────────────┐
                    │     END     │
                    └─────────────┘
```

# FIG. 15

| SELECTIVE TRANSFER LAYER 1610 |
| RELEASE LAYER 1606 |
| DONOR 1600 |

# FIG. 16

| |
|---|
| SELECTIVE TRANSFER LAYER <u>1710</u> |
| TRANSFORMATION LAYER <u>1712</u> |
| RELEASE LAYER <u>1706</u> |
| DONOR <u>1700</u> |

# FIG. 17

| |
|---|
| SELECTIVE TRANSFER LAYER 1810 |
| COMPRESSIVE STRESS LAYER 1812 |
| RELEASE LAYER 1806 |
| DONOR 1800 |

# FIG. 18

| SELECTIVE TRANSFER LAYER 1910 |
| PATTERNED LAYER 1912 |
| RELEASE LAYER 1906 |
| DONOR 1900 |

**FIG. 19**

FIG. 20A

FIG. 20B

FIG. 20C

FIG. 20D

FIG. 20E

SELECTIVE TRANSFER LAYER 2110

2112 {

RELEASE LAYER 2106

DONOR 2100

# FIG. 21

2200

```
        ┌─────────────┐
        │    START    │
        └─────────────┘
               │
               ▼
┌──────────────────────────────────────────────────────┐
│  RECEIVE DONOR SUBSTRATE WITH LAYER OF IC COMPONENTS,  │
│        RELEASE LAYER, AND PROTECTIVE LAYER             │
└──────────────────────────────────────────────────────┘
```

2202

```
               ▼
┌──────────────────────────────────────────────────────┐
│             APPLY LASER TO RELEASE LAYER               │
└──────────────────────────────────────────────────────┘
```

2204

```
               ▼
┌──────────────────────────────────────────────────────┐
│       RELEASE TARGET IC COMPONENTS FROM DONOR /        │
│           SEPARATE DONOR FROM RECEIVER                 │
└──────────────────────────────────────────────────────┘
```

2206

```
               ▼
┌──────────────────────────────────────────────────────┐
│            PERFORM REMAINING PROCESSING                │
└──────────────────────────────────────────────────────┘
```

2208

```
               ▼
        ┌─────────────┐
        │     END     │
        └─────────────┘
```

# FIG. 22

2300

2302

2302

**FIG. 23**

**FIG. 24**

**FIG. 25A**

**FIG. 25B**

**FIG. 25C**

**FIG. 25D**

**FIG. 26**

2700

| PROCESSOR UNIT 2702 | COMMUNICATION COMPONENT 2712 |
|---|---|
| MEMORY 2704 | BATTERY/POWER 2714 |
| DISPLAY DEVICE 2706 | GNSS DEVICE 2718 |
| AUDIO OUTPUT DEVICE 2708 | AUDIO INPUT DEVICE 2724 |
| OTHER OUTPUT DEVICE(S) 2710 | OTHER INPUT DEVICE(S) 2720 |

ANTENNA 2722

# FIG. 27